# EUROPEAN PATENT APPLICATION

(11) **EP 4 700 067 A1**
(43) Date of publication of application: **25.02.2026**
(21) Application number: 25188919.2
(22) Date of filing: 11.07.2025
(51) Int. Cl.: C08G 77/14, C09D 183/06, G03F 7/09, C09D 11/102

(54) **COMPOSITION FOR FORMING SILICON-CONTAINING FILM, METHOD FOR FORMING FILM, AND SUPERSTRATE**

(30) Priority: 24.07.2024 JP 2024118890
(71) Applicant: SHIN-ETSU CHEMICAL CO., LTD., Tokyo 1000005 (JP)
(72) Inventor: Sawamura, Takashi, Niigata (JP); Mitsui, Ryo, Niigata (JP); Matsubara, Satoshi, Niigata (JP)
(74) Representative: Schicker, Silvia

(57) **Abstract**

The present invention is a composition for forming a silicon-containing film, the composition including a condensation-reactive thermally curable silicon-containing material (Sx) being a polysiloxane resin, wherein the material (Sx) has an organic group that forms a diol structure with a plasma treatment, the composition for forming a silicon-containing film has no aromatic ring, and a contact angle of the composition for forming a silicon-containing film after curing and after the plasma treatment relative to pure water is 20 degrees or less. This can provide in a super straight used for inkjet-adaptive planarization: a transparent composition for forming a silicon-containing film that planarizes a contact surface and that provides an appropriate contact angle with a plasma treatment; a method for forming a film using the composition; and a super straight main body using the composition.

## Description

### TECHNICAL FIELD

The present invention relates to a composition for forming a silicon-containing film, a method for forming a film using the composition, and a super straight using the composition.

### BACKGROUND ART

A super straight is used for inkjet-adaptive planarization, and its main body being a glass material is proposed (Patent Document 1). The super straight used for forming a planarizing layer is required to have a completely planar contacting surface, but the completely planar contacting surface cannot be achieved actually, and further improvement of the planar property has been required. The super straight is also required to have ultraviolet-ray transmittance.

As a method for planarizing the contacting surface of the super straight, proposed is a method of laminating a film on a side of the contacting surface of the super straight to improve the planar property (Patent Document 2). However, the outermost surface of the film laminated on the super straight for which a glass material has been commonly used is required to have a contact angle relative to pure water as low as that of glass.

### CITATION LIST

### PATENT LITERATURE

Patent Document 1: JP 2023-081830 A
Patent Document 2: JP 2024-004456 A

### SUMMARY OF INVENTION

### TECHNICAL PROBLEM

The conventional art in the super straight used for the inkjet-adaptive planarization has a challenge of development of a film that can be formed on the super straight, that has ultraviolet-ray transmittance, and that has a planar surface having a low contact angle.

The present invention has been made to solve the above problem. An object of the present invention is to provide, in a super straight used for the inkjet-adaptive planarization: a composition for forming a silicon-containing film that planarizes a contact surface, that has a low contact angle relative to pure water with a plasma treatment, that has transparency, and that has ultraviolet-ray transmittance; a method for forming a film using the composition; and a super straight using the composition.

### SOLUTION TO PROBLEM

To solve the above problem, the present invention provides a composition for forming a silicon-containing film, the composition including a condensation-reactive thermally curable silicon-containing material (Sx) being a polysiloxane resin, wherein
the material (Sx) has an organic group that forms a diol structure with a plasma treatment,
the composition for forming a silicon-containing film has no aromatic ring, and
a contact angle of the composition for forming a silicon-containing film after curing and after the plasma treatment relative to pure water is 20 degrees or less.

The composition for forming a silicon-containing film as above having no aromatic ring can achieve transmissivity usable for the inkjet-adaptive planarization. In addition, containing the polysiloxane resin having an organic group that forms a diol structure with a plasma treatment in the composition for forming a silicon-containing film can achieve the silicon-containing film exhibiting a low contact angle relative to pure water.

In this case, the polysiloxane resin of the material (Sx) preferably includes repeating units represented by the following formula (Sx-1), the following formula (Sx-2), and the following formula (Sx-3), and
the composition for forming a silicon-containing film preferably further includes: the following crosslinking catalyst for polymerizing a siloxane (Xc) having no aromatic ring; an alcoholic organic solvent; and water, 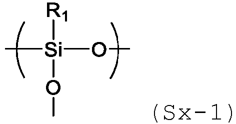
wherein R₁ represents a monovalent organic group having 1 to 20 carbon atoms, having no aromatic ring, optionally having a substituent, and having one or more cyclic structures having an oxygen atom for forming the diol structure with the plasma treatment, 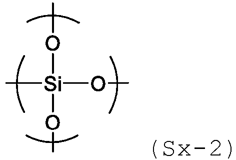 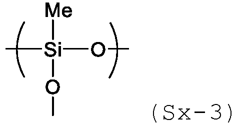
wherein Me represents a methyl group, 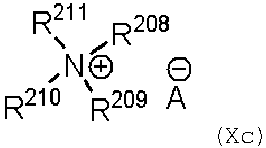
wherein R²⁰⁸, R²⁰⁹, R²¹⁰, and R²¹¹ each represent a hydrogen atom or a linear, branched, or cyclic alkyl group, alkenyl group, oxoalkyl group, or oxoalkenyl group having 1 to 12 carbon atoms, and a part or all of hydrogen atoms in these groups may be substituted with an alkoxy group, etc.; and R²⁰⁸ and R²⁰⁹, or R²⁰¹, R²⁰⁹, and R²¹⁰ may form a ring, and when forming the ring, R²⁰⁸ and R²⁰⁹, and R²⁰¹, R²⁰⁹, and R²¹⁰ represent an alkylene group having 3 to 10 carbon atoms.

Containing the component as above can further improve film formability.

Further, R₁ represented in the general formula (Sx-1) is preferably represented by the following general formula (A-1), and preferably forms the diol structure with the plasma treatment.

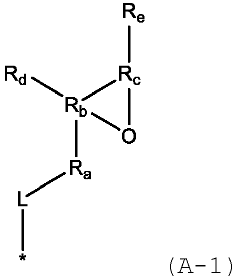

In the formula, L represents a single bond or a divalent organic group having 1 to 5 carbon atoms; R₂, R₃, and R₄ each independently represent an organic group having 1 to 5 carbon atoms and optionally having a substituent; R₅ and R₆ each independently represent a hydrogen atom or an organic group having 1 to 5 carbon atoms and optionally having a substituent, and R₂ and R₆ may form a cyclic structure; and "*" represents an attachment point to a Si atom.

Containing the structure as above can provide a planar surface having ultraviolet-ray transmittance and a low contact angle.

In addition, the present invention provides a method for forming a silicon-containing film, the method including steps of:
forming a carbon hard mask layer on a substrate in which a film is optionally formed on a surface; and
forming a film by curing the above composition for forming a silicon-containing film on the carbon hard mask layer.

The method for forming a silicon-containing film as above is preferably used.

The present invention further provides a method for forming a silicon-containing film, the method including steps of:
forming a carbon hard mask layer on a substrate in which a film is optionally formed on a surface;
forming a film by curing the above composition for forming a silicon-containing film on the carbon hard mask layer; and
subjecting the film to a plasma treatment to set a contact angle of a surface of the formed silicon-containing film relative to pure water to 20 degrees or less.

The method for forming a silicon-containing film as above is preferably used.

The present invention further provides a method for forming a silicon-containing film, the method including a step of applying the above composition for forming a silicon-containing film on a super straight including a quartz substrate or a laminated body, and subjecting the substrate on which the composition for forming a silicon-containing film is applied to a thermal treatment at a temperature of 100°C or higher and 600°C or lower for a range of 10 to 600 seconds to form a cured film.

The thermal treatment under the condition as above can enhance the crosslinking reaction to form an appropriate silicon-containing film.

The present invention further provides a super straight including:
a main body of the super straight;
a first layer having a proximal surface and a distal surface opposite to the proximal surface, wherein the main body is closer to the proximal surface of the first layer than to the distal surface of the first layer; and
a second layer having a proximal surface and a distal surface opposite to the proximal surface, wherein the main body is closer to the proximal surface of the second layer than to the distal surface of the second layer, wherein
the first layer is placed between the main body and the second layer,
the second layer is a cured product of the above composition for forming a silicon-containing film, and
a contact angle of the cured product after a plasma treatment relative to pure water is 20 degrees or less.

The super straight using the composition for forming a silicon-containing film of the present invention has excellent film formability, in-plane uniformity, and light transmittance, and is extremely useful as an organic film material for a super straight used for the inkjet-adaptive planarization.

### ADVANTAGEOUS EFFECTS OF INVENTION

As described above, the composition for forming a silicon-containing film of the present invention can form a planar surface having a low contact angle on, for example, a super straight, can provide a cured film having ultraviolet-ray transmittance, and can provide a super straight having a planar surface usable in the inkjet-adaptive planarization.

### DESCRIPTION OF EMBODIMENTS

Hereinafter, the present invention will be described in more detail. As noted above, there has been a demand for development of the super straight having a planar surface usable in the inkjet-adaptive planarization, and there has been a demand for development of: a composition for forming a silicon-containing film for forming a planar surface having ultraviolet-ray transmittance and a low contact angle on the super straight; and a method for forming a film using the composition.

The present inventors have made earnest study to achieve the above object, and consequently found that a cured film of a composition for forming a silicon-containing film containing a polysiloxane resin having no aromatic ring and having a specific structure that forms a diol structure with a plasma treatment yields the transparent and highly planar film having a low contact angle usable for the inkjet-adaptive planarization. This finding has led to completion of the present invention.

Specifically, the present invention is a composition for forming a silicon-containing film, the composition including a condensation-reactive thermally curable silicon-containing material (Sx) being a polysiloxane resin, wherein
the material (Sx) has an organic group that forms a diol structure with a plasma treatment,
the composition for forming a silicon-containing film has no aromatic ring, and
a contact angle of the composition for forming a silicon-containing film after curing and after the plasma treatment relative to pure water is 20 degrees or less.

Hereinafter, the present invention will be described in detail, but the present invention is not limited thereto.

### [Composition for Forming Film]

The composition for forming a silicon-containing film of the present invention is a composition for forming a silicon-containing film, the composition including a condensation-reactive thermally curable silicon-containing material (Sx) being a polysiloxane resin, wherein
the material (Sx) has an organic group that forms a diol structure with a plasma treatment,
the composition for forming a silicon-containing film has no aromatic ring, and
a contact angle of the composition for forming a silicon-containing film after curing and after the plasma treatment relative to pure water is 20 degrees or less. The composition may contain other optional components in addition thereto.

In the composition for forming a silicon-containing film of the present invention, the film formability can be further improved by the polysiloxane resin of the material (Sx) including repeating units represented by the following formula (Sx-1), the following formula (Sx-2), and the following formula (Sx-3), wherein the composition for forming a silicon-containing film further includes: the crosslinking catalyst for polymerizing a siloxane (Xc) having no aromatic ring; an alcoholic organic solvent; and water, 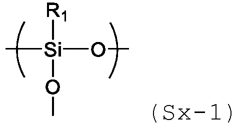
wherein R₁ represents a monovalent organic group having 1 to 20 carbon atoms, having no aromatic ring, optionally having a substituent, and having one or more cyclic structures having an oxygen atom for forming the diol structure with the plasma treatment, 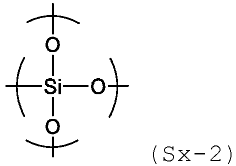 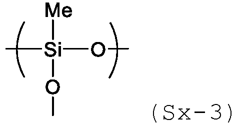
wherein Me represents a methyl group, 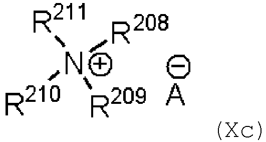
wherein R²⁰⁸, R²⁰⁹, R²¹⁰, and R²¹¹ each represent a hydrogen atom or a linear, branched, or cyclic alkyl group, alkenyl group, oxoalkyl group, or oxoalkenyl group having 1 to 12 carbon atoms, and a part or all of hydrogen atoms in these groups may be substituted with an alkoxy group, etc.; and R²⁰⁸ and R²⁰⁹, or R²⁰¹, R²⁰⁹, and R²¹⁰ may form a ring, and when forming the ring, R²⁰⁸ and R²⁰⁹, and R²⁰¹, R²⁰⁹, and R²¹⁰ represent an alkylene group having 3 to 10 carbon atoms.

Hereinafter, each component contained in the composition for forming a silicon-containing film of the present invention will be described in detail.

The "condensation-reactive thermally curable silicon-containing material" may be simply referred to as "thermally crosslinkable polysiloxane" herein.

### Condensation-Reactive Thermally Curable Silicon-Containing Material (Sx)

For the composition for forming a silicon-containing film of the present invention, the condensation-reactive thermally curable silicon-containing material (Sx) being a polysiloxane resin may be used.

In the condensation-reactive thermally curable silicon-containing material (Sx) of the present invention, the composition for forming a silicon-containing film having an organic group that forms a diol structure with a plasma treatment and having no aromatic ring can set a contact angle of the composition for forming a silicon-containing film after curing and after the plasma treatment relative to pure water to 20 degrees or less.

In this case, the condensation-reactive thermally curable silicon-containing material (Sx) of the present invention may have repeating units represented by the following formula (Sx-1), the following formula (Sx-2), and the following formula (Sx-3).

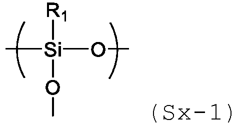

In the formula, R₁ represents a monovalent organic group having 1 to 20 carbon atoms, having no aromatic ring, optionally having a substituent, and having one or more cyclic structures having an oxygen atom for forming the diol structure with the plasma treatment,

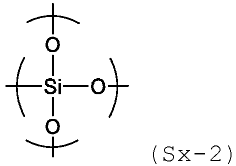

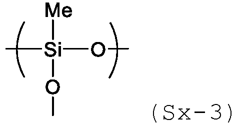

In the formula, Me represents a methyl group.

R₁ in the general formula (Sx-1) represents a monovalent organic group having 1 to 20 carbon atoms, having no aromatic ring, optionally having a substituent, and having one or more cyclic structures having an oxygen atom for forming the diol structure with the plasma treatment.

In the general formula (Sx-1), the monovalent organic group R₁ having 1 to 20 carbon atoms, having no aromatic ring, and optionally having a substituent is more specifically represented by the following general formula (A-1).

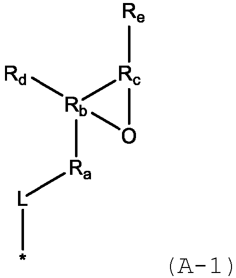

In the formula, L represents a single bond or a divalent organic group having 1 to 5 carbon atoms; R₂, R₃, and R₄ each independently represent an organic group having 1 to 5 carbon atoms and optionally having a substituent; R₅ and R₆ each independently represent a hydrogen atom or an organic group having 1 to 5 carbon atoms and optionally having a substituent, and R₂ and R₆ may form a cyclic structure; and **"*"** represents an attachment point to a Si atom.

The composition having the structure as above can provide the planar surface having ultraviolet-ray transmittance and a low contact angle.

More specific examples of the structural unit represented by the formula (A-1) include, but not limited to, the following structures.

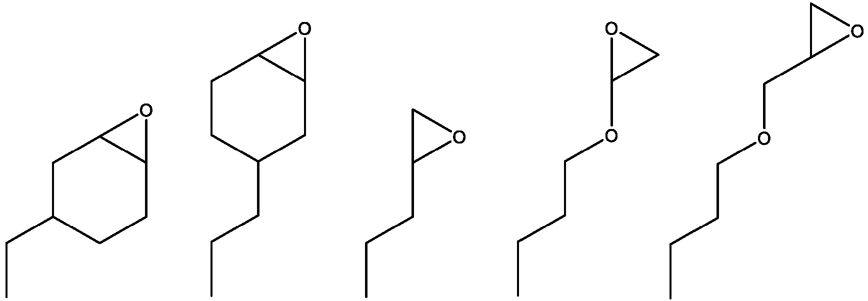

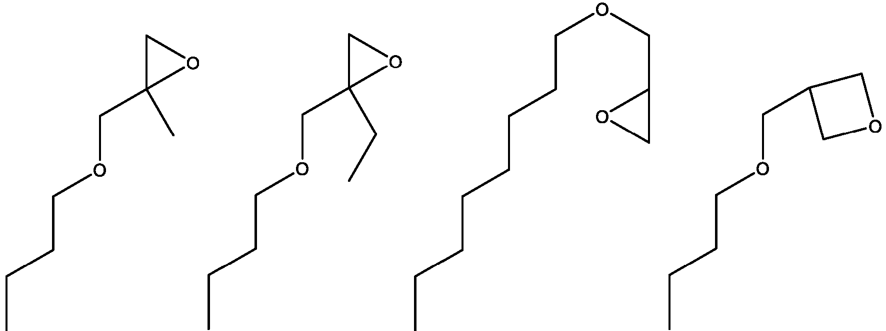

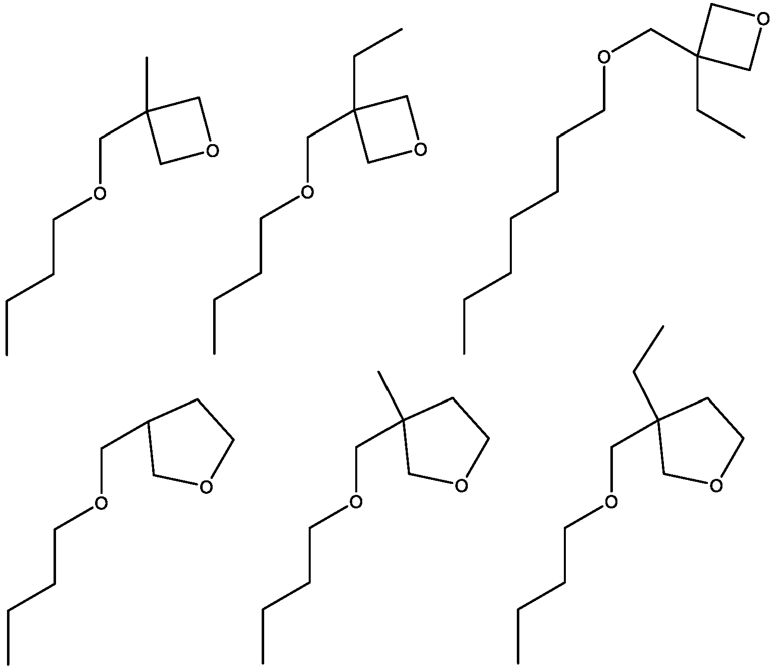

R₁ represented in the general formula (Sx-1) can have the structure represented by the general formula (A-1) that forms a diol structure with the plasma treatment. More specific examples thereof include, but not limited to, the following structures.

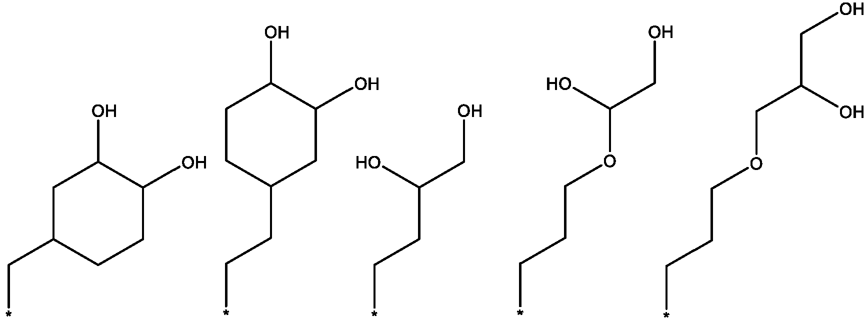

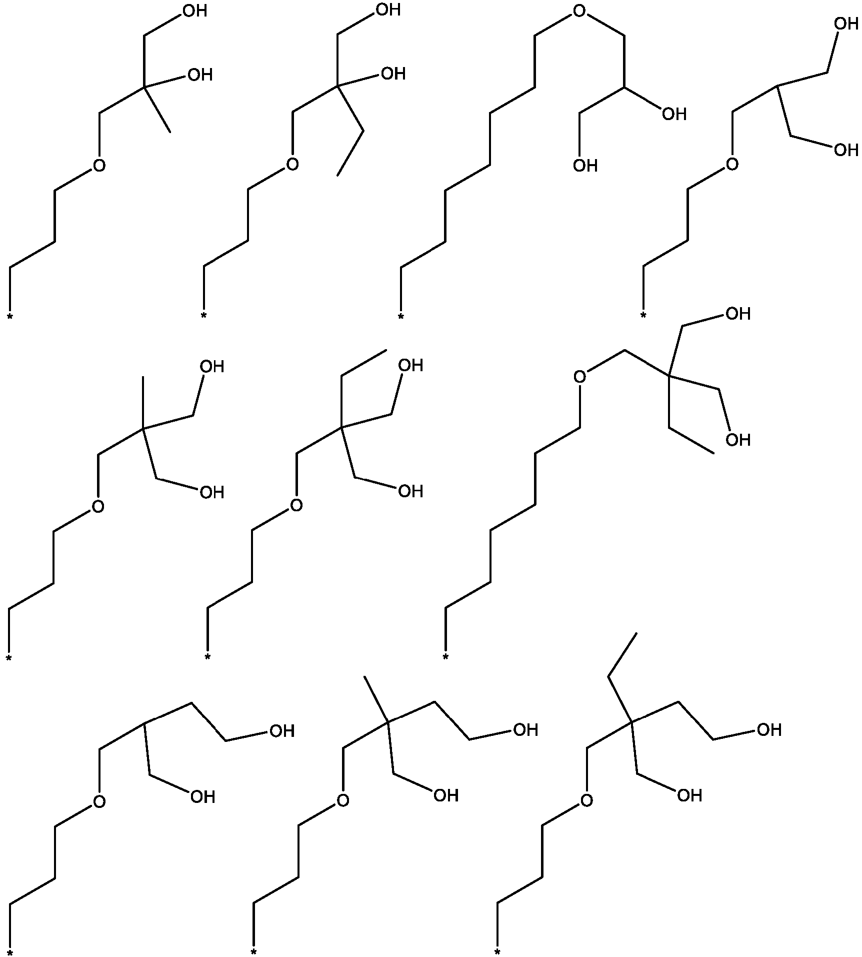

The above condensation-reactive thermally curable silicon-containing material (Sx) can be produced by hydrolytic condensation of the following hydrolysable monomer (Sm), for example.

Specific examples of the hydrolysable monomer (Sm) include tetramethoxysilane, tetraethoxysilane, tetrapropoxysilane, tetraisopropoxysilane, trimethoxysilane, triethoxysilane, tripropoxysilane, triisopropoxysilane, methyltrimethoxysilane, methyltriethoxysilane, methyltripropoxysilane, methyltriisopropoxysilane, ethyltrimethoxysilane, ethyltriethoxysilane, ethyltripropoxysilane, ethyltriisopropoxysilane, vinyltrimethoxysilane, vinyltriethoxysilane, vinyltripropoxysilane, vinyltriisopropoxysilane, propyltrimethoxysilane, propyltriethoxysilane, propyltripropoxysilane, propyltriisopropoxysilane, isopropyltrimethoxysilane, isopropyltriethoxysilane, isopropyltripropoxysilane, isopropyltriisopropoxysilane, butyltrimethoxysilane, butyltriethoxysilane, butyltripropoxysilane, butyltriisopropoxysilane, isobutyltrimethoxysilane, isobutyltriethoxysilane, isobutyltripropoxysilane, isobutyltriisopropoxysilane, sec-butyltrimethoxysilane, sec-butyltriethoxysilane, sec-butyltripropoxysilane, sec-butyltriisopropoxysilane, t-butyltrimethoxysilane, t-butyltriethoxysilane, t-butyltripropoxysilane, t-butyltriisopropoxysilane, allyltrimethoxysilane, allyltriethoxysilane, allyltripropoxysilane, allyltriisopropoxysilane, cyclopropyltrimethoxysilane, cyclopropyltriethoxysilane, cyclopropyltripropoxysilane, cyclopropyltriisopropoxysilane, cyclobutyltrimethoxysilane, cyclobutyltriethoxysilane, cyclobutyltripropoxysilane, cyclobutyltriisopropoxysilane, cyclopentyltrimethoxysilane, cyclopentyltriethoxysilane, cyclopentyltripropoxysilane, cyclopentyltriisopropoxysilane, cyclohexyltrimethoxysilane, cyclohexyltriethoxysilane, cyclohexyltripropoxysilane, cyclohexyltriisopropoxysilane, cyclohexenyltrimethoxysilane, cyclohexenyltriethoxysilane, cyclohexenyltripropoxysilane, cyclohexenyltriisopropoxysilane, cyclohexenylethyltrimethoxysilane, cyclohexenylethyltriethoxysilane, cyclohexenylethyltripropoxysilane, cyclohexenylethyltriisopropoxysilane, cyclooctyltrimethoxysilane, cyclooctyltriethoxysilane, cyclooctyltripropoxysilane, cyclooctyltriisopropoxysilane, cyclopentadienylpropyltrimethoxysilane, cyclopentadienylpropyltriethoxysilane, cyclopentadienylpropyltripropoxysilane, cyclopentadienylpropyltriisopropoxysilane, bicycloheptenyltrimethoxysilane, bicycloheptenyltriethoxysilane, bicycloheptenyltripropoxysilane, bicycloheptenyltriisopropoxysilane, bicycloheptyltrimethoxysilane, bicycloheptyltriethoxysilane, bicycloheptyltripropoxysilane, bicycloheptyltriisopropoxysilane, adamantyltrimethoxysilane, adamantyltriethoxysilane, adamantyltripropoxysilane, adamantyltriisopropoxysilane, dimethyldimethoxysilane, dimethyldiethoxysilane, methylethyldimethoxysilane, methylethyldiethoxysilane, dimethyldipropoxysilane, dimethyldiisopropoxysilane, diethyldimethoxysilane, diethyldiethoxysilane, diethyldipropoxysilane, diethyldiisopropoxysilane, dipropyldimethoxysilane, dipropyldiethoxysilane, dipropyldipropoxysilane, dipropyldiisopropoxysilane, diisopropyldimethoxysilane, diisopropyldiethoxysilane, diisopropyldipropoxysilane, diisopropyldiisopropoxysilane, dibutyldimethoxysilane, dibutyldiethoxysilane, dibutyldipropoxysilane, dibutyldiisopropoxysilane, di-sec-butyldimethoxysilane, di-sec-butyldiethoxysilane, di-sec-butyldipropoxysilane, di-sec-butyldiisopropoxysilane, di-t-butyldimethoxysilane, di-t-butyldiethoxysilane, di-t-butyldipropoxysilane, di-t-butyldiisopropoxysilane, dicyclopropyldimethoxysilane, dicyclopropyldiethoxysilane, dicyclopropyldipropoxysilane, dicyclopropyldiisopropoxysilane, dicyclobutyldimethoxysilane, dicyclobutyldiethoxysilane, dicyclobutyldipropoxysilane, dicyclobutyldiisopropoxysilane, dicyclopentyldimethoxysilane, dicyclopentyldiethoxysilane, dicyclopentyldipropoxysilane, dicyclopentyldiisopropoxysilane, dicyclohexyldimethoxysilane, dicyclohexyldiethoxysilane, dicyclohexyldipropoxysilane, dicyclohexyldiisopropoxysilane, dicyclohexenyldimethoxysilane, dicyclohexenyldiethoxysilane, dicyclohexenyldipropoxysilane, dicyclohexenyldiisopropoxysilane, dicyclohexenylethyldimethoxysilane, dicyclohexenylethyldiethoxysilane, dicyclohexenylethyldipropoxysilane, dicyclohexenylethyldiisopropoxysilane, dicyclooctyldimethoxysilane, dicyclooctyldiethoxysilane, dicyclooctyldipropoxysilane, dicyclooctyldiisopropoxysilane, dicyclopentadienylpropyldimethoxysilane, dicyclopentadienylpropyldiethoxysilane, dicyclopentadienylpropyldipropoxysilane, dicyclopentadienylpropyldiisopropoxysilane, bis(dicycloheptenyl)dimethoxysilane, bis(dicycloheptenyl)diethoxysilane, bis(dicycloheptenyl)dipropoxysilane, bis(dicycloheptenyl)diisopropoxysilane, bis(dicycloheptyl)dimethoxysilane, bis(dicycloheptyl)diethoxysilane, bis(dicycloheptyl)dipropoxysilane, bis(dicycloheptyl)diisopropoxysilane, diadamantyldimethoxysilane, diadamantyldiethoxysilane, diadamantyldipropoxysilane, diadamantyldiisopropoxysilane, trimethylmethoxysilane, trimethylethoxysilane, and dimethylethylmethoxysilane.

Examples of the above compound preferably include tetramethoxysilane, tetraethoxysilane, methyltrimethoxysilane, methyltriethoxysilane, ethyltrimethoxysilane, ethyltriethoxysilane, vinyltrimethoxysilane, vinyltriethoxysilane, propyltrimethoxysilane, propyltriethoxysilane, isopropyltrimethoxysilane, isopropyltriethoxysilane, butyltrimethoxysilane, butyltriethoxysilane, isobutyltrimethoxysilane, isobutyltriethoxysilane, allyltrimethoxysilane, allyltriethoxysilane, cyclopentyltrimethoxysilane, cyclopentyltriethoxysilane, cyclohexyltrimethoxysilane, cyclohexyltriethoxysilane, cyclohexenyltrimethoxysilane, cyclohexenyltriethoxysilane, phenyltrimethoxysilane, phenyltriethoxysilane, benzyltrimethoxysilane, benzyltriethoxysilane, phenethyltrimethoxysilane, phenethyltriethoxysilane, dimethyldimethoxysilane, dimethyldiethoxysilane, diethyldimethoxysilane, diethyldiethoxysilane, methylethyldimethoxysilane, methylethyldiethoxysilane, dipropyldimethoxysilane, dibutyldimethoxysilane, trimethylmethoxysilane, and dimethylethylmethoxysilane.

### [Method for Synthesizing Thermally Crosslinkable Polysiloxane (Sx)]

### (Synthesis Method 1: Acid Catalyst)

The thermally crosslinkable polysiloxane (Sx) used in the present invention can be produced by hydrolytic condensation of a hydrolysable monomer (Sm) or a mixture of two or more hydrolysable monomers (Sm) in the presence of an acid catalyst.

Examples of the acid catalyst used in this case include organic acids such as formic acid, acetic acid, oxalic acid, maleic acid, and methanesulfonic acid, hydrofluoric acid, hydrochloric acid, hydrobromic acid, sulfuric acid, nitric acid, perchloric acid, and phosphoric acid. A use amount of the catalyst is preferably 1×10⁻⁶ to 10 mol, more preferably 1×10⁻⁵ to 5 mol, and further preferably 1×10⁻⁴ to 1 mol relative to 1 mol of the monomer.

In obtaining the thermally crosslinkable polysiloxane (Sx) from these monomers by hydrolytic condensation, water is added at an amount of preferably 0.01 to 100 mol, more preferably 0.05 to 50 mol, and further preferably 0.1 to 30 mol per mole of the hydrolysable substituent bonded to the monomer. The amount of 100 mol or less allows an apparatus used for the reaction to be small, which is economical. The amount of 0.01 mol or more allows the reaction to proceed sufficiently.

As the operation method, the monomer is added into an aqueous solution of the catalyst to initiate the hydrolytic condensation reaction. In this case, an organic solvent may be added in the aqueous solution of the catalyst, the monomer may be diluted in advance with an organic solvent, or both of them may be performed. The reaction temperature is preferably 0 to 100°C, and more preferably 5 to 80°C. In a preferable method, the temperature is kept at 5 to 80°C during dropwise addition of the monomer, and the mixture is then aged at 20 to 80°C.

Preferable as the organic solvent that can be added in the aqueous solution of the catalyst, or that can dilute the monomer are methanol, ethanol, 1-propanol, 2-propanol, 1-butanol, 2-butanol, 2-methyl-1-propanol, ethylene glycol, propylene glycol, acetone, acetonitrile, tetrahydrofuran, toluene, hexane, ethyl acetate, acetone, methyl ethyl ketone, methyl isobutyl ketone, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, t-butyl propionate, propylene glycol mono-t-butyl ether acetate, γ-butyrolactone, acetonitrile, tetrahydrofuran, a mixture thereof, etc.

Among these organic solvents, water-soluble organic solvents are preferable. Examples thereof include: alcohols such as methanol, ethanol, 1-propanol, and 2-propanol; polyhydric alcohols such as ethylene glycol and propylene glycol; polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, and ethylene glycol monopropyl ether; and acetone, acetonitrile, and tetrahydrofuran. Among these, organic solvents having a boiling point of 100°C or lower are particularly preferable.

A use amount of the organic solvent is preferably 0 to 1,000 ml, and particularly preferably 0 to 500 ml relative to 1 mol of the monomer. A lower use amount of the organic solvent allows a reaction vessel to be small, which is economical.

Thereafter, a neutralization reaction for the catalyst is performed to obtain an aqueous solution of the reaction mixture if necessary. In this case, an amount of an alkaline substance usable for the neutralization is preferably 0.1 to 2 equivalents relative to the acid used as the catalyst. This alkaline substance may be any substance exhibiting alkalinity in water.

Subsequently, byproducts such as an alcohol generated by the hydrolytic condensation reaction is preferably removed from the aqueous solution of the reaction mixture by removal under a reduced pressure. In this case, a temperature at which the aqueous solution of the reaction mixture is heated is preferably 0 to 100°C, more preferably 10 to 90°C, and further preferably 15 to 80°C, depending on the types of the added organic solvent and the alcohol generated by the reaction, etc. A pressure reducing degree in this case is preferably the atmospheric pressure or lower, more preferably 80 kPa or lower as an absolute pressure, and further preferably 50 kPa or lower as an absolute pressure, which varies depending on types of the organic solvent and the alcohol to be removed, a ventilation apparatus, a condensation apparatus, and the heating temperature. Although it is difficult to accurately determine an amount of the removed alcohol in this case, approximately 80 mass% or more of the generated alcohol, etc. is desirably removed.

Then, the acid catalyst used for the hydrolytic condensation may be removed from the aqueous solution of the reaction mixture. As a method for removing the acid catalyst, water and the thermally crosslinkable polysiloxane solution are mixed, and the thermally crosslinkable polysiloxane is extracted with an organic solvent. The organic solvent used in this case is preferably an organic solvent that can dissolve the thermally crosslinkable polysiloxane and that forms separated two layers when mixed with water. Examples thereof include methanol, ethanol, 1-propanol, 2-propanol, 1-butanol, 2-butanol, 2-methyl-1-propanol, acetone, tetrahydrofuran, toluene, hexane, ethyl acetate, acetone, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, methyl isobutyl ketone, cyclopentyl methyl ether, tetrahydrofuran, and a mixture thereof.

Furthermore, a mixture of a water-soluble organic solvent and a water-hardly-soluble organic solvent can also be used. Examples of preferable mixtures include a methanol-ethyl acetate mixture, an ethanol-ethyl acetate mixture, a 1-propanol-ethyl acetate mixture, a 2-propanol-ethyl acetate mixture, a butanediol monomethyl ether-ethyl acetate mixture, a propylene glycol monomethyl ether-ethyl acetate mixture, an ethylene glycol monomethyl ether-ethyl acetate mixture, a butanediol monoethyl ether-ethyl acetate mixture, a propylene glycol monoethyl ether-ethyl acetate mixture, an ethylene glycol monoethyl ether-ethyl acetate mixture, a butanediol monopropyl ether-ethyl acetate mixture, a propylene glycol monopropyl ether-ethyl acetate mixture, an ethylene glycol monopropyl ether-ethyl acetate mixture, a methanol-methyl isobutyl ketone mixture, an ethanol-methyl isobutyl ketone mixture, a 1-propanol-methyl isobutyl ketone mixture, a 2-propanol-methyl isobutyl ketone mixture, a propylene glycol monomethyl ether-methyl isobutyl ketone mixture, an ethylene glycol monomethyl ether-methyl isobutyl ketone mixture, a propylene glycol monoethyl ether-methyl isobutyl ketone mixture, an ethylene glycol monoethyl ether-methyl isobutyl ketone mixture, a propylene glycol monopropyl ether-methyl isobutyl ketone mixture, an ethylene glycol monopropyl ether-methyl isobutyl ketone mixture, a methanol-cyclopentyl methyl ether mixture, an ethanol-cyclopentyl methyl ether mixture, a 1-propanol-cyclopentyl methyl ether mixture, a 2-propanol-cyclopentyl methyl ether mixture, a propylene glycol monomethyl ether-cyclopentyl methyl ether mixture, an ethylene glycol monomethyl ether-cyclopentyl methyl ether mixture, a propylene glycol monoethyl ether-cyclopentyl methyl ether mixture, an ethylene glycol monoethyl ether-cyclopentyl methyl ether mixture, a propylene glycol monopropyl ether-cyclopentyl methyl ether mixture, an ethylene glycol monopropyl ether-cyclopentyl methyl ether mixture, a methanol-propylene glycol methyl ether acetate mixture, an ethanol-propylene glycol methyl ether acetate mixture, a 1-propanol-propylene glycol methyl ether acetate mixture, a 2-propanol-propylene glycol methyl ether acetate mixture, a propylene glycol monomethyl ether-propylene glycol methyl ether acetate mixture, an ethylene glycol monomethyl ether-propylene glycol methyl ether acetate mixture, a propylene glycol monoethyl ether-propylene glycol methyl ether acetate mixture, an ethylene glycol monoethyl ether-propylene glycol methyl ether acetate mixture, a propylene glycol monopropyl ether-propylene glycol methyl ether acetate mixture, and an ethylene glycol monopropyl ether-propylene glycol methyl ether acetate mixture. The combination is not limited thereto.

A mixing ratio between the water-soluble organic solvent and the water-hardly-soluble organic solvent is appropriately selected, and is preferably 0.1 to 1,000 parts by mass, more preferably 1 to 500 parts by mass, and further preferably 2 to 100 parts by mass of the water-soluble organic solvent relative to 100 parts by mass of the water-hardly-soluble organic solvent.

Subsequently, the reaction mixture may be washed with neutral water. As this water, so-called deionized water or ultrapure water is typically used. An amount of this water is preferably 0.01 to 100 L, more preferably 0.05 to 50 L, and further preferably 0.1 to 5 L relative to 1 L of the solution of the thermally crosslinkable polysiloxane. In this washing method, the both are added into one vessel, and the mixture is stirred and then left to stand to separate the aqueous layer. The washing time is one or more, and preferably one to approximately five because even ten times or more of washing does not yield an expected effect.

Examples of another method for removing the acid catalyst include: a method with an ion-exchange resin; and a method of neutralization with an epoxy compound such as ethylene oxide and propylene oxide, and then removing the neutralized product. These methods can be appropriately selected according to the acid catalyst used for the reaction.

The washing procedure in this time with water may allow a part of the thermally crosslinkable polysiloxane to escape into the aqueous layer and yield an effect approximately same as a fractioning procedure. Thus, the washing time with water and the amount of washing water are appropriately selected with considering the effect of removing the catalyst and the effect of fractioning.

In any of the solution of the thermally crosslinkable polysiloxane with a remained acid catalyst and the solution of the thermally crosslinkable polysiloxane in which the acid catalyst has been removed, a final solvent is added and solvent exchange is performed under a reduced pressure to obtain a solution of the desired thermally crosslinkable polysiloxane. A temperature of the solvent exchange in this case is preferably 0 to 100°C, more preferably 10 to 90°C, and further preferably 15 to 80°C, depending on types of the reaction solvent and extraction solvent to be removed. A pressure reducing degree in this case is preferably the atmospheric pressure or lower, more preferably 80 kPa or lower as an absolute pressure, and further preferably 50 kPa or lower as an absolute pressure, which varies depending on a type of the extraction solvent to be removed, a ventilation apparatus, a condensation apparatus, and the heating temperature.

In this case, the thermally crosslinkable polysiloxane may be destabilized by changing the solvent. This destabilization is caused by compatibility between the final solvent and the thermally crosslinkable polysiloxane. To prevent this destabilization, an alcohol having one or two or more hydroxy groups and having a cyclic ether as a substituent described in paragraphs (0181) to (0182) in JP 2009-126940 A may be added as a stabilizer. An amount of the stabilizer to be added is preferably 0 to 25 parts by mass, more preferably 0 to 15 parts by mass, and further preferably 0 to 5 parts by mass relative to 100 parts by mass of the thermally crosslinkable polysiloxane in the solution before the solvent exchange. When the stabilizer is added, the amount is preferably 0.5 parts by mass or more. If necessary, the alcohol having one or two or more hydroxy groups and having a cyclic ether as a substituent is added into the solution before the solvent exchange, and then the solvent exchange procedure is performed.

The thermally crosslinkable polysiloxane is preferably in a solution state at an appropriate concentration. The concentration in this case is preferably 0.1 to 20 mass%. The concentration as above prevents a further condensation reaction, and prevents change to a state impossible to be soluble again in the organic solvent. In addition, an amount of the solvent is reduced, which is consequently economical and preferable.

The final solvent added into the solution of the thermally crosslinkable polysiloxane is preferably an alcoholic solvent. Particularly preferable alcoholic solvents are monoalkyl ether derivatives of ethylene glycol, diethylene glycol, triethylene glycol, propylene glycol, dipropylene glycol, butanediol, etc. Specifically, the preferable solvents include butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, diacetone alcohol, etc.

When these solvents are the main component, non-alcoholic solvents may be added as an auxiliary solvent. Examples of this auxiliary solvent include acetone, tetrahydrofuran, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, methyl isobutyl ketone, and cyclopentyl methyl ether.

As another reaction procedure using the acid catalyst, water or a water-containing organic solvent is added into the monomer or an organic solution of the monomer to initiate the hydrolysis reaction. In this case, the catalyst may be added into the monomer or the organic solution of the monomer, or may be added in advance into the water or the water-containing organic solvent. The reaction temperature is preferably 0 to 100°C, and more preferably 10 to 80°C. A preferable method is heating during dropwise addition of the water to 10 to 50°C, and then raising the temperature to 20 to 80°C for aging.

When being used, the organic solvent is preferably water-soluble. Examples thereof include methanol, ethanol, 1-propanol, 2-propanol, 1-butanol, 2-butanol, 2-methyl-1-propanol, acetone, tetrahydrofuran, acetonitrile, polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether, and a mixture thereof.

An amount of the used organic solvent is preferably 0 to 1,000 ml, and particularly preferably 0 to 500 ml relative to 1 mol of the monomer. When the amount of the used organic solvent is smaller, a reaction vessel may be smaller, which is economical. The obtained aqueous solution of the reaction mixture can be aftertreated in the same manner as the above method to obtain the thermally crosslinkable polysiloxane.

### (Synthesis Method 2: Alkali Catalyst)

The thermally crosslinkable polysiloxane (Sx) can be produced by hydrolytic condensation of a hydrolysable monomer (Sm) or a mixture of two or more hydrolysable monomers (Sm) in the presence of an alkali catalyst. Examples of the alkali catalyst used in this case include methylamine, ethylamine, propylamine, butylamine, ethylenediamine, hexamethylenediamine, dimethylamine, diethylamine, ethylmethylamine, trimethylamine, triethylamine, tripropylamine, tributylamine, cyclohexylamine, dicyclohexylamine, monoethanolamine, diethanolamine, dimethylmonoethanolamine, monomethyldiethanolamine, triethanolamine, diazabicyclooctane, diazabicyclononene, diazabicycloundecene, hexamethylenetetramine, aniline, N,N-dimethylaniline, pyridine, N,N-dimethylaminopyridine, pyrrole, piperazine, pyrrolidine, piperidine, picoline, tetramethylammonium hydroxide, choline hydroxide, tetrapropylammonium hydroxide, tetrabutylammonium hydroxide, ammonia, lithium hydroxide, sodium hydroxide, potassium hydroxide, barium hydroxide, and calcium hydroxide. An amount of the used catalyst is preferably 1×10⁻⁶ to 10 mol, more preferably 1×10⁻⁵ to 5 mol, and further preferably 1×10⁻⁴ to 1 mol relative to 1 mol of the monomer.

An amount of water added in obtaining the thermally crosslinkable polysiloxane from the monomer by the hydrolytic condensation is preferably 0.1 to 50 mol per mole of the hydrolysable substituent bonded to the monomer. The amount of 50 mol or less allows an apparatus used for the reaction to be small, which is economical. The amount of 0.1 mol or more allows the reaction to proceed sufficiently.

As the operation method, the monomer is added into an aqueous solution of the catalyst to initiate the hydrolytic condensation reaction. In this case, an organic solvent may be added in the aqueous solution of the catalyst, the monomer may be diluted in advance with an organic solvent, or both of them may be performed. The reaction temperature is preferably 0 to 100°C, and more preferably 5 to 80°C. In a preferable method, the temperature is kept at 5 to 80°C during dropwise addition of the monomer, and the mixture is then aged at 20 to 80°C.

Preferably used organic solvents that can be added into the aqueous solution of the alkali catalyst or that can dilute the monomer include the same organic solvents as the exemplified organic solvent that can be added into the aqueous solution of the acid catalyst. An amount of the used organic solvent is preferably 0 to 1,000 ml relative to 1 mol of the monomer for the economical reaction.

Thereafter, a neutralization reaction of the catalyst is performed to obtain an aqueous solution of the reaction mixture if necessary. In this case, an amount of an acidic substance that can be used for the neutralization is preferably 0.1 to 2 equivalents relative to the used alkaline substance as the catalyst. This acidic substance may be any substance exhibiting acidity in water.

Subsequently, byproducts such as an alcohol generated by the hydrolytic condensation reaction is preferably removed from the aqueous solution of the reaction mixture by removal under a reduced pressure, etc. In this time, a temperature at which the aqueous solution of the reaction mixture is heated is preferably 0 to 100°C, more preferably 10 to 90°C, and further preferably 15 to 80°C, depending on types of the added organic solvent and alcohol generated in the reaction. A pressure reducing degree in this case is preferably the atmospheric pressure or lower, more preferably 80 kPa or lower as an absolute pressure, and further preferably 50 kPa or lower as an absolute pressure, which varies depending on types of the organic solvent and alcohol to be removed, a ventilation apparatus, a condensation apparatus, and the heating temperature. Although it is difficult to accurately determine an amount of the removed alcohol in this case, approximately 80 mass% or more of the generated alcohol is desirably removed.

Then, to remove the catalyst used for the hydrolytic condensation, the thermally crosslinkable polysiloxane is extracted with an organic solvent. The organic solvent used in this case is preferably an organic solvent that can dissolve the thermally crosslinkable polysiloxane and that forms separated two layers when mixed with water. Examples thereof include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, methyl isobutyl ketone, cyclopentyl methyl ether, and a mixture thereof.

Furthermore, a mixture of a water-soluble organic solvent and a water-hardly-soluble organic solvent can also be used.

Specific examples of the organic solvent used for removing the alkali catalyst include: the specifically exemplified organic solvents used for removing the acid catalyst; and the same mixture as the mixture of the water-soluble organic solvent and the water-hardly soluble organic solvent.

A mixing ratio between the water-soluble organic solvent and the water-hardly-soluble organic solvent is appropriately selected, and is preferably 0.1 to 1,000 parts by mass, more preferably 1 to 500 parts by mass, and further preferably 2 to 100 parts by mass of the water-soluble organic solvent relative to 100 parts by mass of the water-hardly-soluble organic solvent.

Subsequently, the reaction mixture is washed with neutral water. As this water, so-called deionized water or ultrapure water is typically used. An amount of this water is preferably 0.01 to 100 L, more preferably 0.05 to 50 L, and further preferably 0.1 to 5 L relative to 1 L of the solution of the thermally crosslinkable polysiloxane. In this washing method, the both are added into one vessel, and the mixture is stirred and then left to stand to separate the aqueous layer. The washing time is one or more, and preferably one to approximately five because even ten times or more of washing does not yield an expected effect.

Into the washed solution of the thermally crosslinkable polysiloxane, a final solvent is added and solvent exchange is performed under a reduced pressure to obtain a solution of the desired thermally crosslinkable polysiloxane. A temperature in the solvent exchange in this case is preferably 0 to 100°C, more preferably 10 to 90°C, and further preferably 15 to 80°C, depending on a type of the extraction solvent to be removed. A pressure reducing degree in this case is preferably the atmospheric pressure or lower, more preferably 80 kPa or lower as an absolute pressure, and further preferably 50 kPa or lower as an absolute pressure, which varies depending on a type of the extraction solvent to be removed, a ventilation apparatus, a condensation apparatus, and the heating temperature.

The final solvent added into the solution of the thermally crosslinkable polysiloxane is preferably an alcoholic solvent, and particularly preferably monoalkyl ether derivatives of ethylene glycol, diethylene glycol, triethylene glycol, propylene glycol, dipropylene glycol, etc. Specifically, preferable solvents include propylene glycol monomethyl ether, ethylene glycol monomethyl ether, propylene glycol monoethyl ether, ethylene glycol monoethyl ether, propylene glycol monopropyl ether, ethylene glycol monopropyl ether, and diacetone alcohol.

As another reaction procedure using the alkali catalyst, water or a water-containing organic solvent is added into the monomer or an organic solution of the monomer to initiate the hydrolysis reaction. In this case, the catalyst may be added into the monomer or the organic solution of the monomer, or may be added in advance into the water or the water-containing organic solvent. The reaction temperature is preferably 0 to 100°C, and more preferably 10 to 80°C. A preferable method is heating during dropwise addition of the water to 10 to 50°C, and then raising the temperature to 20 to 80°C for aging.

The organic solvent usable as the organic solution of the monomer or the water-containing organic solvent is preferably water-soluble. Examples thereof include methanol, ethanol, 1-propanol, 2-propanol, 1-butanol, **2-**butanol, 2-methyl-1-propanol, acetone, tetrahydrofuran, acetonitrile, polyhydric alcohol condensate derivatives such as propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, propylene glycol monopropyl ether, and a mixture thereof.

A molecular weight of the thermally crosslinkable polysiloxane obtained by the above synthetic method 1 or 2 can be regulated by not only selecting the monomer but also controlling the reaction condition in the polymerization. Since the weight-average molecular weight of 100,000 or less does not cause occurrence of foreign matters and coating unevenness, the thermally crosslinkable polysiloxane having a weight-average molecular weight of preferably 100,000 or less, more preferably 200 to 50,000, and further preferably 300 to 30,000 is preferably used. The data about the weight-average molecular weight indicate the molecular weight in terms of polystyrene by gel permeation chromatography (GPC) using RI as a detector, tetrahydrofuran as an eluent solvent, and polystyrene as a standard substance.

The thermally crosslinkable polysiloxane used in the present invention has different physical properties depending on types of the acid or alkali catalyst used in the hydrolytic condensation and the reaction condition. Thus, the catalyst and the reaction condition can be appropriately selected according to target performance of the silicon-containing film.

Further, a polysiloxane derivative produced from the hydrolysable monomer (Sm) or a mixture of two or more of the hydrolysable monomer (Sm) and a hydrolysable metal compound represented by the following general formula (Mm) under the condition using the acid or alkali catalyst may be used as a component in the composition for forming a silicon-containing film.

U(OR⁷)ₘ₇(OR⁸)ₘ₈(Mm)

In the general formula (Mm), R⁷ and R⁸ each independently represent an organic group having 1 to 30 carbon atoms, m7+m8 is the same number as a valency determined by a type of U, m7 and m8 represent an integer of 0 or more, and U represents a III-group, IV-group, or V-group element in the periodic table except for carbon and silicon.

Examples of the hydrolysable metal compound represented by the general formula (Mm) used in this case include the following compounds. When U represents boron, examples of the hydrolysable metal compound represented by the general formula (Mm) include boron methoxide, boron ethoxide, boron propoxide, boron butoxide, boron amyloxide, boron hexyloxide, boron cyclopentoxide, boron cyclohexyloxide, boron allyloxide, boron phenoxide, boron methoxyethoxide, boric acid, and boron oxide.

When U represents aluminum, examples of the hydrolysable metal compound represented by the general formula (Mm) include aluminum methoxide, aluminum ethoxide, aluminum propoxide, aluminum butoxide, aluminum amyloxide, aluminum hexyloxide, aluminum cyclopentoxide, aluminum cyclohexyloxide, aluminum allyloxide, aluminum phenoxide, aluminum methoxyethoxide, aluminum ethoxyethoxide, aluminum dipropoxy ethylacetoacetate, aluminum dibutoxy ethylacetoacetate, aluminum propoxy bisethylacetoacetate, aluminum butoxy bisethylacetoacetate, aluminum 2,4-pentanedionate, and aluminum 2,2,6,6-tetramethyl-3,5-heptanedionate.

When U represents gallium, examples of the hydrolysable metal compound represented by the general formula (Mm) include gallium methoxide, gallium ethoxide, gallium propoxide, gallium butoxide, gallium amyloxide, gallium hexyloxide, gallium cyclopentoxide, gallium cyclohexyloxide, gallium allyloxide, gallium phenoxide, gallium methoxyethoxide, gallium ethoxyethoxide, gallium dipropoxy ethylacetoacetate, gallium dibutoxy ethylacetoacetate, gallium propoxy bisethylacetoacetate, gallium butoxy bisethylacetoacetate, gallium 2,4-pentanedionate, and gallium 2,2,6,6-tetramethyl-3,5-heptanedionate.

When U represents yttrium, examples of the hydrolysable metal compound represented by the general formula (Mm) include yttrium methoxide, yttrium ethoxide, yttrium propoxide, yttrium butoxide, yttrium amyloxide, yttrium hexyloxide, yttrium cyclopentoxide, yttrium cyclohexyloxide, yttrium allyloxide, yttrium phenoxide, yttrium methoxyethoxide, yttrium ethoxyethoxide, yttrium dipropoxy ethylacetoacetate, yttrium dibutoxy ethylacetoacetate, yttrium propoxy bisethylacetoacetate, yttrium butoxy bisethylacetoacetate, yttrium 2,4-pentanedionate, and yttrium 2,2,6,6-tetramethyl-3,5-heptanedionate.

When U represents germanium, examples of the hydrolysable metal compound represented by the general formula (Mm) include germanium methoxide, germanium ethoxide, germanium propoxide, germanium butoxide, germanium amyloxide, germanium hexyloxide, germanium cyclopentoxide, germanium cyclohexyloxide, germanium allyloxide, germanium phenoxide, germanium methoxyethoxide, and germanium ethoxyethoxide.

When U represents titanium, examples of the hydrolysable metal compound represented by the general formula (Mm) include titanium methoxide, titanium ethoxide, titanium propoxide, titanium butoxide, titanium amyloxide, titanium hexyloxide, titanium cyclopentoxide, titanium cyclohexyloxide, titanium allyloxide, titanium phenoxide, titanium methoxyethoxide, titanium ethoxyethoxide, titanium dipropoxy bisethylacetoacetate, titanium dibutoxy bisethylacetoacetate, titanium dipropoxy bis-2,4-pentanedionate, and titanium dibutoxy bis-2,4-pentanedionate.

When U represents hafnium, examples of the hydrolysable metal compound represented by the general formula (Mm) include hafnium methoxide, hafnium ethoxide, hafnium propoxide, hafnium butoxide, hafnium amyloxide, hafnium hexyloxide, hafnium cyclopentoxide, hafnium cyclohexyloxide, hafnium allyloxide, hafnium phenoxide, hafnium methoxyethoxide, hafnium ethoxyethoxide, hafnium dipropoxy bisethylacetoacetate, hafnium dibutoxy bisethylacetoacetate, hafnium dipropoxy bis-2,4-pentanedionate, and hafnium dibutoxy bis-2,4-pentanedionate.

When U represents tin, examples of the hydrolysable metal compound represented by the general formula (Mm) include methoxytin, ethoxytin, propoxytin, butoxytin, phenoxytin, methoxyethoxytin, ethoxyethoxytin, tin 2,4-pentanedionate, and tin 2,2,6,6-tetramethyl-3,5-heptanedionate.

When U represents arsenic, examples of the hydrolysable metal compound represented by the general formula (Mm) include methoxyarsenic, ethoxyarsenic, propoxyarsenic, butoxyarsenic, and phenoxyarsenic.

When U represents antimony, examples of the hydrolysable metal compound represented by the general formula (Mm) include methoxyantimony, ethoxyantimony, propoxyantimony, butoxyantimony, phenoxyantimony, antimony acetate, and antimony propionate.

When U represents niobium, examples of the hydrolysable metal compound represented by the general formula (Mm) include methoxyniobium, ethoxyniobium, propoxyniobium, butoxyniobium, and phenoxyniobium.

When U represents tantalum, examples of the hydrolysable metal compound represented by the general formula (Mm) include methoxytantalum, ethoxytantalum, propoxytantalum, butoxytantalum, and phenoxytantalum.

When U represents bismuth, examples of the hydrolysable metal compound represented by the general formula (Mm) include methoxybismuth, ethoxybismuth, propoxybismuth, butoxybismuth, and phenoxybismuth.

When U represents phosphorus, examples of the hydrolysable metal compound represented by the general formula (Mm) include trimethyl phosphate, triethyl phosphate, tripropyl phosphate, trimethyl phosphite, triethyl phosphite, tripropyl phosphite, and diphosphorus pentoxide.

When U represents vanadium, examples of the hydrolysable metal compound represented by the general formula (Mm) include vanadium oxide bis(2,4-pentanedionate), vanadium 2,4-pentanedionate, vanadium tributoxide oxide, and vanadium tripropoxide oxide.

When U represents zirconium, examples of the hydrolysable metal compound represented by the general formula (Mm) include methoxyzirconium, ethoxyzirconium, propoxyzirconium, butoxyzirconium, phenoxyzirconium, zirconium dibutoxide bis(2,4-pentanedionate), and zirconium dipropoxide bis(2,2,6,6-tetramethyl-3,5-heptanedionate).

In the composition for forming a silicon-containing film of the present invention, a blending amount of the thermally crosslinkable polysiloxane (Sx) is preferably 0.1 to 10 mass% relative to the solvent, for example.

### [Solvent]

The solvent used in the composition for forming a silicon-containing film of the present invention is preferably an alcoholic solvent, and particularly preferably monoalkyl ether derivatives of ethylene glycol, diethylene glycol, triethylene glycol, propylene glycol, dipropylene glycol, butanediol, etc. Specifically, preferable are butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, diacetone alcohol, etc.

When these solvents are the main component, non-alcoholic solvents may be added as an auxiliary solvent. Examples of this auxiliary solvent include acetone, tetrahydrofuran, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, methyl isobutyl ketone, and cyclopentyl methyl ether.

### [Crosslinking Catalyst]

In the composition for forming a silicon-containing film of the present invention, the crosslinking catalyst is preferably blended. Examples of the crosslinking catalyst that can be blended include compounds represented by the following general formula (Xc).

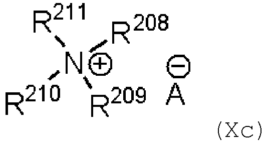

In the formula, R²⁰⁸, R²⁰⁹, R²¹⁰, and R²¹¹ each represent a hydrogen atom or a linear, branched, or cyclic alkyl group, alkenyl group, oxoalkyl group, or oxoalkenyl group having 1 to 12 carbon atoms, and a part or all of hydrogen atoms in these groups may be substituted with an alkoxy group, etc.; and R²⁰⁸ and R²⁰⁹, or R²⁰¹, R²⁰⁹, and R²¹⁰ may form a ring, and when forming the ring, R²⁰⁸ and R²⁰⁹, and R²⁰⁸, R²⁰⁹, and R²¹⁰ represent an alkylene group having 3 to 10 carbon atoms.

The R²⁰⁸, R²⁰⁹, R²¹⁰, and R²¹¹ may be same as or different from each other. Specific examples of the alkyl group include a methyl group, an ethyl group, a propyl group, an isopropyl group, a n-butyl group, a sec-butyl group, a tert-butyl group, a pentyl group, a hexyl group, a heptyl group, an octyl group, a cyclopentyl group, a cyclohexyl group, a cycloheptyl group, a cyclopropylmethyl group, a 4-methylcyclohexyl group, a cyclohexylmethyl group, a norbornyl group, and an adamantyl group. Examples of the alkenyl group include a vinyl group, an allyl group, a propenyl group, a butenyl group, a hexenyl group, and a cyclohexenyl group. Examples of the oxoalkyl group include a 2-oxocyclopentyl group, a 2-oxocyclohexyl group, a 2-oxopropyl group, a 2-cyclopentyl-2-oxoethyl group, a 2-cyclohexyl-2-oxoethyl group, and a 2-(4-methylcyclohexyl)-2-oxoethyl group. Examples of the oxoalkenyl group include a 2-oxopropenyl group, a 2-oxobutenyl group, a 2-oxohexenyl group, a 2-oxocyclopentenyl group, and a 2-oxocyclohexenyl group.

Examples of the non-nucleophilic counterion of A⁻include: monovalent ions such as a hydroxide ion, a formate ion, an acetate ion, a propionate ion, a butanoate ion, a pentanoate ion, a hexanoate ion, a heptanoate ion, an octanoate ion, a nonanoate ion, a decanoate ion, an oleate ion, a stearate ion, a linoleate ion, a linolenate ion, a trifluoroacetate ion, a monochloroacetate ion, a dichloroacetate ion, a trichloroacetate ion, a fluoride ion, a chloride ion, a bromide ion, an iodide ion, a nitrate ion, a nitrite ion, a chlorate ion, a bromate ion, a methanesulfonate ion, and a monomethylsulfate ion; and monovalent or divalent ions of an oxalate ion, a malonate ion, a methylmalonate ion, an ethylmalonate ion, a propylmalonate ion, a butylmalonate ion, a dimethylmalonate ion, a diethylmalonate ion, a succinate ion, a methylsuccinate ion, a glutarate ion, an adipate ion, an itaconate ion, a maleate ion, a fumarate ion, a citraconate ion, a citrate ion, a carbonate ion, and a sulfate ion.

Specific examples of the crosslinking catalyst for polymerizing a siloxane (Xc) include tetramethylammonium formate, tetramethylammonium acetate, tetramethylammonium propionate, tetramethylammonium butanoate, tetramethylammonium trifluoromethanesulfonate, tetramethylammonium trifluoroacetate, tetramethylammonium monochloroacetate, tetramethylammonium dichloroacetate, tetramethylammonium trichloroacetate, tetramethylammonium hydroxide, tetramethylammonium nitrate, tetramethylammonium chloride, tetramethylammonium bromide, tetramethylammonium iodide, tetramethylammonium monomethylsulfate, tetramethylammonium oxalate, tetramethylammonium malonate, tetramethylammonium maleate, tetramethylammonium fumarate, tetramethylammonium citraconate, tetramethylammonium citrate, tetramethylammonium carbonate, bistetramethylammonium oxalate, bistetramethylammonium malonate, bistetramethylammonium maleate, bistetramethylammonium fumarate, bistetramethylammonium citraconate, bistetramethylammonium citrate, bistetramethylammonium carbonate, tetraethylammonium formate, tetraethylammonium acetate, tetraethylammonium propionate, tetraethylammonium butanoate, tetraethylammonium trifluoromethanesulfonate, tetraethylammonium trifluoroacetate, tetraethylammonium monochloroacetate, tetraethylammonium dichloroacetate, tetraethylammonium trichloroacetate, tetraethylammonium hydroxide, tetraethylammonium nitrate, tetraethylammonium chloride, tetraethylammonium bromide, tetraethylammonium iodide, tetraethylammonium monomethylsulfate, tetraethylammonium oxalate, tetraethylammonium malonate, tetraethylammonium maleate, tetraethylammonium fumarate, tetraethylammonium citraconate, tetraethylammonium citrate, tetraethylammonium carbonate, bistetraethylammonium oxalate, bistetraethylammonium malonate, bistetraethylammonium maleate, bistetraethylammonium fumarate, bistetraethylammonium citraconate, bistetraethylammonium citrate, bistetraethylammonium carbonate, tetrapropylammonium formate, tetrapropylammonium acetate, tetrapropylammonium propionate, tetrapropylammonium butanoate, tetrapropylammonium trifluoromethanesulfonate, tetrapropylammonium trifluoroacetate, tetrapropylammonium monochloroacetate, tetrapropylammonium dichloroacetate, tetrapropylammonium trichloroacetate, tetrapropylammonium hydroxide, tetrapropylammonium nitrate, tetrapropylammonium chloride, tetrapropylammonium bromide, tetrapropylammonium iodide, tetrapropylammonium monomethylsulfate, tetrapropylammonium oxalate, tetrapropylammonium malonate, tetrapropylammonium maleate, tetrapropylammonium fumarate, tetrapropylammonium citraconate, tetrapropylammonium citrate, tetrapropylammonium carbonate, bistetrapropylammonium oxalate, bistetrapropylammonium malonate, bistetrapropylammonium maleate, bistetrapropylammonium fumarate, bistetrapropylammonium citraconate, bistetrapropylammonium citrate, bistetrapropylammonium carbonate, tetrabutylammonium formate, tetrabutylammonium acetate, tetrabutylammonium propionate, tetrabutylammonium butanoate, tetrabutylammonium trifluoromethanesulfonate, tetrabutylammonium trifluoroacetate, tetrabutylammonium monochloroacetate, tetrabutylammonium dichloroacetate, tetrabutylammonium trichloroacetate, tetrabutylammonium hydroxide, tetrabutylammonium nitrate, tetrabutylammonium chloride, tetrabutylammonium bromide, tetrabutylammonium iodide, tetrabutylammonium methanesulfonate, tetrabutylammonium monomethylsulfate, tetrabutylammonium oxalate, tetrabutylammonium malonate, tetrabutylammonium maleate, tetrabutylammonium fumarate, tetrabutylammonium citraconate, tetrabutylammonium citrate, tetrabutylammonium carbonate, bistetrabutylammonium oxalate, bistetrabutylammonium malonate, bistetrabutylammonium maleate, bistetrabutylammonium fumarate, bistetrabutylammonium citraconate, bistetrabutylammonium citrate, and bistetrabutylammonium carbonate.

In the present invention, a polysiloxane (Xc-10) having an ammonium salt as a part of the structure may be blended as the crosslinking catalyst for polymerizing a siloxane (Xc) in the composition for forming a silicon-containing film.

As a raw material used for producing (Xc-10) used herein, a compound represented by the following general formula (Xm) may be used.

R^{1A}_{A1}R^{2A}_{A2}R^{3A}_{A3}Si(OR^{OA})_{(4-A1-A2-A3)} (Xm)

In the general formula (Xm), R^{0A} represents a hydrocarbon group having 1 to 6 carbon atoms; at least one of R^{1A}, R^{2A}, and R^{RA} represents an organic group having an ammonium salt, a sulfonium salt, a phosphonium salt, or an iodonium salt, and the others represent a hydrogen atom or a monovalent organic group having 1 to 30 carbon atoms; and A1, A2, and A3 represent 0 or 1, and satisfy 1 ≤ A1+A2+A3 ≤ 3.

Examples of R^{0A} include a methyl group, an ethyl group, a n-propyl group, an iso-propyl group, a n-butyl group, an iso-butyl group, a sec-butyl group, a tert-butyl group, a n-pentyl group, a cyclopentyl group, a n-hexyl group, and a cyclohexyl group.

As Xm, examples of the hydrolysable silicon compound having an ammonium salt as a part of the structure may include compounds represented by the following general formula (Xm-4).

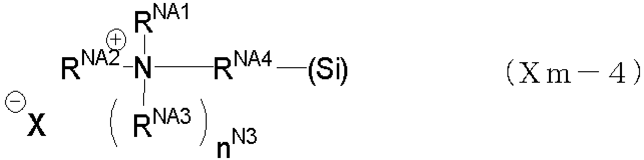

In the general formula (Xm-4), R^{NA1}, R^{NA2}, and R^{NA3} each represent a hydrogen atom or a linear, branched, or cyclic alkyl group, alkenyl group, oxoalkyl group, or oxoalkenyl group having 1 to 20 carbon atoms, and a part or all of hydrogen atoms in these groups may be substituted with an alkoxy group, an amino group, an alkylamino group, etc., and R^{NA1} and R^{NA2} may form a ring together with a nitrogen atom to which R^{NA1} and R^{NA2} are bonded, and when forming the ring, R^{NA1} and R^{NA2} each represent an alkylene group having 1 to 6 carbon atoms or a cyclic heteroring having a nitrogen; R^{NA4} represents a linear, branched, or cyclic alkylene group or alkenylene group having 1 to 20 carbon atoms, and a part or all of hydrogen atoms in these groups may be substituted with an alkoxy group, an amino group, an alkylamino group, etc.; when R^{NA1} and R^{NA2} or R^{NA1} and R^{NA4} form a cyclic structure and further have an unsaturated nitrogen, n^{N3} = 0, and in the other cases, n^{N3} = 1.

In the general formula (Xm-4), (Si) is noted for describing a bonding position to Si. X⁻ is the same as the A⁻.

Specific examples of a cation moiety of the compound represented by the general formula (Xm-4) include the following ions.

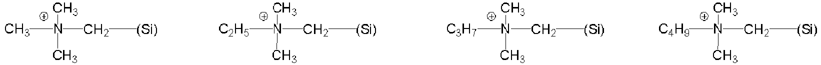

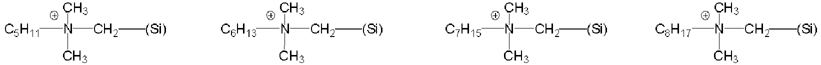

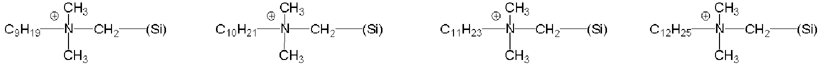

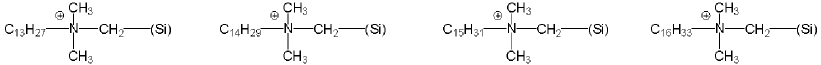

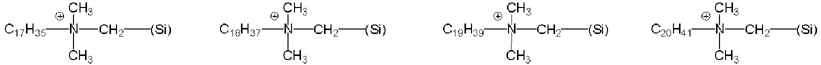

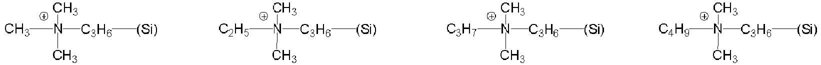

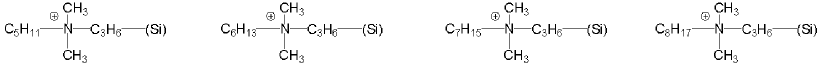

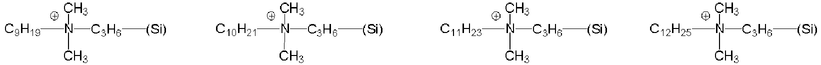

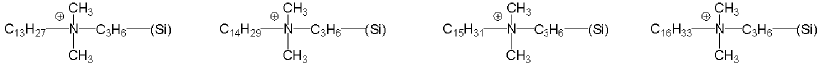

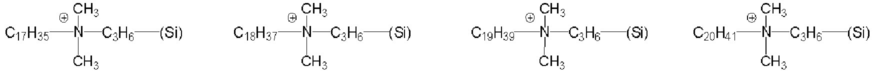

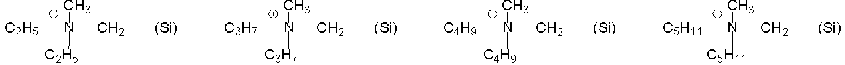

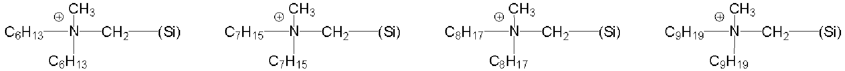

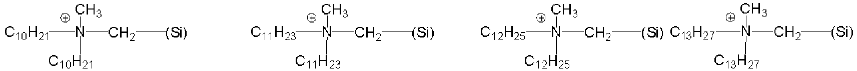

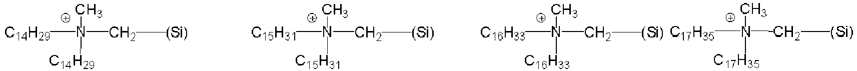

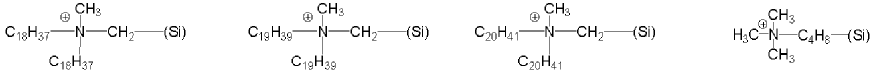

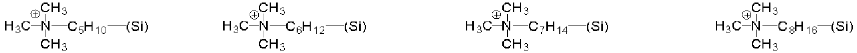

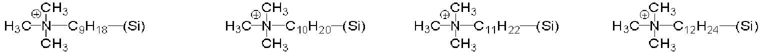

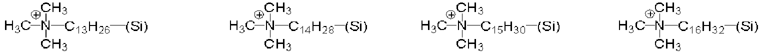

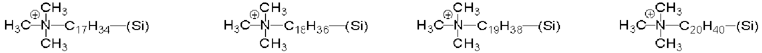

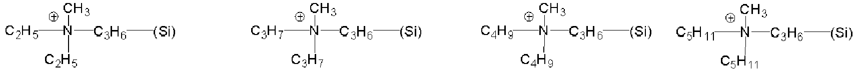

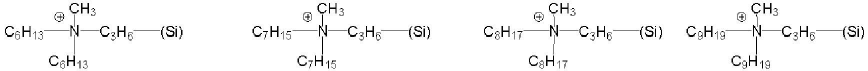

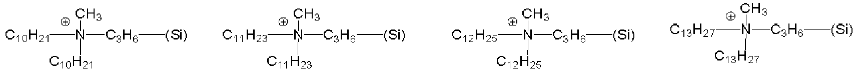

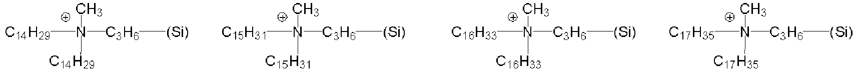

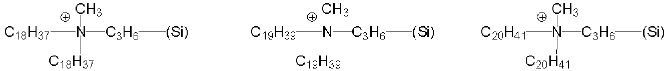

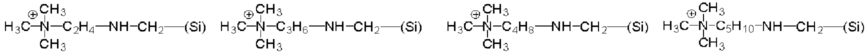

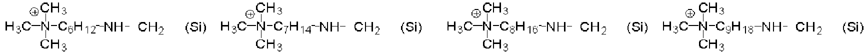

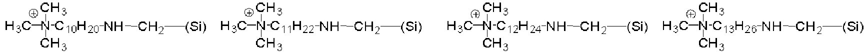

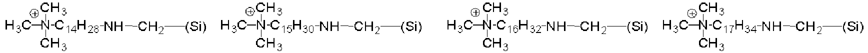

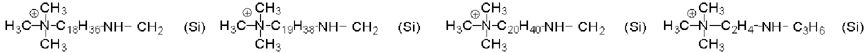

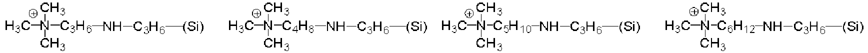

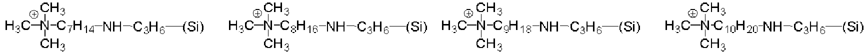

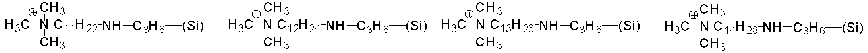

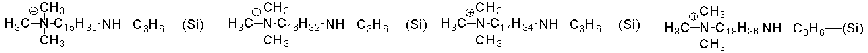

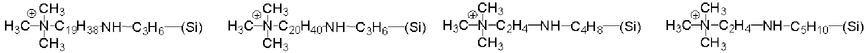

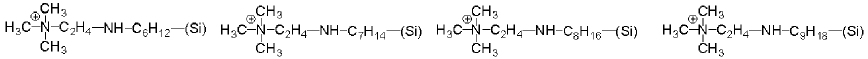

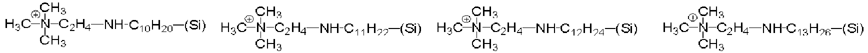

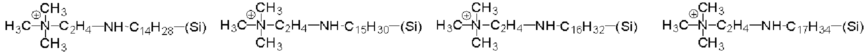

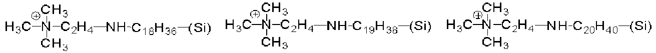

Examples of a hydrolysable silicon compound used for producing (Xc-10) simultaneously with (Xm-4) include the above hydrolysable monomer (Sm). The hydrolysable metal compound (Mm) represented by the general formula (Mm) may be further added.

One or more of the monomers (Xm-4) and (Sm) as described above, and one or more (Mm) may be further selected if necessary, and mixed before the reaction or during the reaction to be reaction raw materials for forming (Xc-10). The reaction condition may be the same condition as in the synthesis method of the thermally crosslinkable polysiloxane (Sx).

A molecular weight of the obtained crosslinking catalyst (Xc-10) can be regulated by not only selecting the monomer but also controlling the reaction condition in the polymerization. Since the weight-average molecular weight of 100,000 or less does not cause occurrence of foreign matters and coating unevenness, the crosslinking catalyst (Xc-10) having a weight-average molecular weight of preferably 100,000 or less, more preferably 200 to 50,000, and further preferably 300 to 30,000, is preferably used. The data about the weight-average molecular weight indicate the molecular weight in terms of polystyrene by gel permeation chromatography (GPC) using RI as a detector, tetrahydrofuran as an eluent solvent, and polystyrene as a standard substance.

The crosslinking catalysts (Xc) and (Xc-10) may be used singly or in combination of two or more thereof. An addition amount of the crosslinking catalyst is preferably 0.01 to 50 parts by mass, and more preferably 0.1 to 40 parts by mass relative to 100 parts by mass of the base polymer (the thermally crosslinkable polysiloxane (Sx) obtained by the above method).

### Organic Acid

To improve stability of the composition for forming a silicon-containing film of the present invention, an organic acid having one or two or more acid groups and having 1 to 30 carbon atoms is preferably added. Examples of the acid added in this case may include formic acid, acetic acid, propionic acid, butanoic acid, pentanoic acid, hexanoic acid, heptanoic acid, octanoic acid, nonanoic acid, decanoic acid, oleic acid, stearic acid, linoleic acid, linolenic acid, trifluoroacetic acid, monochloroacetic acid, dichloroacetic acid, trichloroacetic acid, oxalic acid, malonic acid, methylmalonic acid, ethylmalonic acid, propylmalonic acid, butylmalonic acid, dimethylmalonic acid, diethylmalonic acid, succinic acid, methylsuccinic acid, glutaric acid, adipic acid, itaconic acid, maleic acid, fumaric acid, citraconic acid, and citric acid. Particularly, oxalic acid, maleic acid, formic acid, acetic acid, propionic acid, citric acid, etc. are preferable. To retain the stability, two or more acids may be mixed for use. An addition amount of the organic acid is preferably 0.001 to 25 parts by mass, more preferably 0.01 to 15 parts by mass, and further preferably 0.1 to 5 parts by mass relative to 100 parts by mass of the silicon-containing material (Sx) contained in the composition for forming a silicon-containing film of the present invention.

Alternatively, the organic acid is preferably blended so that a pH in terms of the composition for forming a silicon-containing film of the present invention preferably satisfy 0 ≤ pH ≤ 7, more preferably 0.3 ≤ pH ≤ 6.5, and further preferably 0.5 ≤ pH ≤ 6.

### [Water]

In the present invention, water may be added into the composition for forming a silicon-containing film. Adding water hydrates the polysiloxane compound in the composition for forming a silicon-containing film of the present invention, thereby improving film-curing performance. A content rate of water in the solvent component in the composition for forming a silicon-containing film of the present invention is preferably more than 0 mass% and less than 50 mass%, particularly preferably 0.3 to 30 mass%, and further preferably 0.5 to 20 mass%. When the addition amount of water is less than 50 mass%, uniformity of the silicon-containing film becomes good, and repellency does not occur. Meanwhile, the addition amount of water of more than 0 mass% improves the film-curing performance.

### [Stabilizer]

In the present invention, a stabilizer may be further added into the composition for forming a silicon-containing film. As the stabilizer, an alcohol having one or two or more hydroxy groups and having a cyclic ether as a substituent may be added. Specifically, adding a stabilizer described in paragraphs (0181) to (0182) of JP 2009-126940 A can improve the stability of the composition for forming a silicon-containing film. A blending amount of the stabilizer is preferably 0 to 50 parts by mass, and more preferably 0 to 40 parts by mass relative to 100 parts by mass of the thermally crosslinkable polysiloxane (Sx) being the base polymer.

### [Surfactant]

In the present invention, a surfactant may be further blended into the composition for forming a silicon-containing film. Specifically, materials described in a paragraph (0185) of JP 2009-126940 A may be added as the above surfactant. A blending amount of the surfactant is preferably 0 to 10 parts by mass, and more preferably 0 to 5 parts by mass relative to 100 parts by mass of the polysiloxane resin.

### [Method for Forming Film]

The present invention provides a method for forming a silicon-containing film used in the production process of semiconductor devices, the method including a step of applying the above composition for forming a silicon-containing film of the present invention on a super straight including a quartz substrate or a laminated body by spin-coating to form a coating film, and subjecting the coating film to a thermal treatment at a temperature of 100°C or higher and 600°C or lower for a range of 10 to 600 seconds for curing to form a silicon-containing film. For example, the super straight having the quartz substrate or the laminated body coated with the above composition for forming a silicon-containing film is subjected to the thermal treatment within the ranges of temperature and time for curing to form the silicon-containing film.

In this method for forming a silicon-containing film, the aforementioned silicon-containing composition for forming of the present invention is rotationally applied (spin-coating) on the substrate to be processed. Use of the spin-coating method can yield a good planarization property. After the applying, baking (the thermal treatment) is performed to enhance the crosslinking reaction. Since this baking can evaporate the solvent in the composition, mixing can be prevented also when another film is formed on the silicon-containing film.

The baking is performed at a temperature of 100°C or higher and 600°C or lower within the range of 10 to 600 seconds, and preferably a temperature of 200°C or higher and 500°C or lower within a range of 10 to 300 seconds. The thermal treatment under the condition as above can enhance the crosslinking reaction to form the appropriate silicon-containing film.

Further, the formed silicon-containing film forms a diol structure with a plasma treatment. This can form the appropriate silicon-containing film as a super straight surface exhibiting a contact angle of 20 degrees or less.

### [Carbon Hard Mask Layer]

The carbon hard mask layer used in the method for forming a silicon-containing film of the present invention include, but not limited to, a spin-on-carbon, a polymer, and a chemical vapor deposition or physical vapor deposition carbon film.

The method for forming a silicon-containing film of the present invention provides a method for forming a silicon-containing film, the method including steps of:
forming a carbon hard mask layer on a substrate in which a film is optionally formed on a surface; and
forming a film by curing the above composition for forming a silicon-containing film on the carbon hard mask layer.

The method for forming a silicon-containing film of the present invention provides a method for forming a silicon-containing film, the method including steps of:
forming a carbon hard mask layer on a substrate in which a film is optionally formed on a surface;
forming a film by curing the above composition for forming a silicon-containing film on the carbon hard mask layer; and
subjecting the film to a plasma treatment to set a contact angle of a surface of the formed silicon-containing film relative to pure water to 20 degrees or less.

### [Super Straight]

Methods for forming a planarizing layer on a substrate include inkjet-based adaptive planarization (IAP) as described in US 2009/0080922 A. The IAP includes allocating droplet patterns of a formable material on a substrate. Then, the material is contacted with the super straight and the droplet pattern. Thereafter, the formable material between the super straight and the substrate is cured. Then, the super straight is removed. The cured formable material has a shape of an upper layer.

The substrate and the cured formable material are then subjected to steps such as imprint lithography, photolithography, baking, oxidation, layer formation, deposition, baking, etching, descumming, dicing, bonding, and packaging, but the steps are not limited thereto. The substrate and the material can be subjected to known steps and processes in order to produce devices (articles).

As noted above, the present invention can provide a super straight including:
a main body of the super straight;
a first layer having a proximal surface and a distal surface opposite to the proximal surface, wherein the main body is closer to the proximal surface of the first layer than to the distal surface of the first layer; and
a second layer having a proximal surface and a distal surface opposite to the proximal surface, wherein the main body is closer to the proximal surface of the second layer than to the distal surface of the second layer, wherein
the first layer is placed between the main body and the second layer,
the second layer is a cured product of the above composition for forming a silicon-containing film, and
a contact angle of the cured product after a plasma treatment relative to pure water is 20 degrees or less.

### EXAMPLE

Hereinafter, the present invention will be specifically described with showing Synthesis Examples, Comparative Synthesis Examples, Examples, and Comparative Examples, but the present invention is not limited by these descriptions. In the following example, "%" represents "mass%", and a molecular weight Mw is a weight-average molecular weight in terms of polystyrene by GPC measurement.

Monomers used for synthesis were as follows.

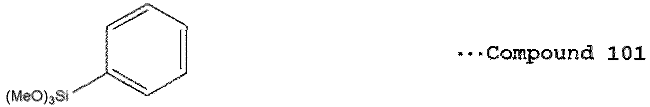

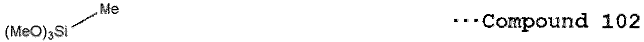

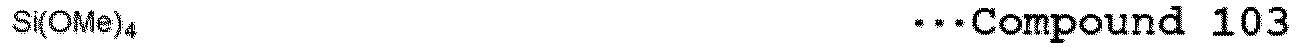

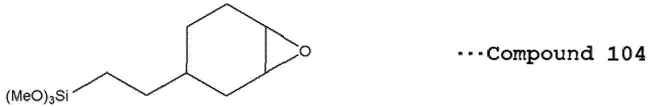

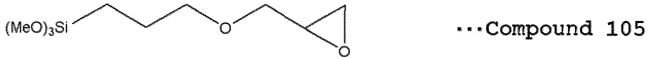

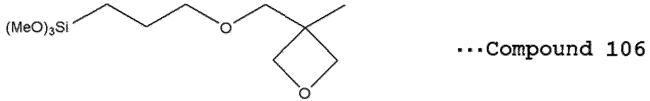

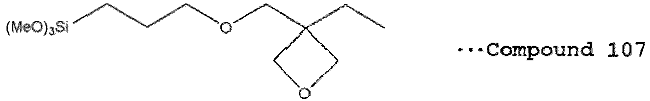

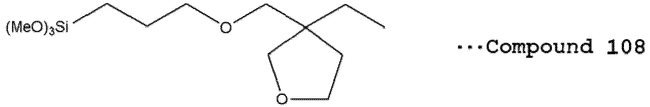

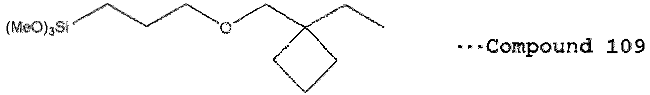

### [Synthesis Example 1-1]

Into a mixture of 75 g of deionized water and 0.5 g of 7% nitric acid, a mixture of 11.4 g of the compound (102), 30.6 g of the compound (103), and 3.7 g of the compound (104) was added (mole ratio: 28/67/5), and the mixture was retained at 25°C for 24 hours to perform hydrolytic condensation. After the reaction was finished, 450 g of propylene glycol monoethyl ether (PGEE) and 1.0 g of a 24% maleic acid aqueous solution were added, and the water content used for the hydrolytic condensation and a byproduct alcohol were distilled off under a reduced pressure to obtain 240 g of a PGEE solution of a polysiloxane resin A1 (resin concentration: 10%). A molecular weight of the polysiloxane resin A1 in terms of polystyrene was measured to Mw = 2,550.

### [Synthesis Example 1-2]

Into a mixture of 75 g of deionized water and 0.5 g of 7% nitric acid, a mixture of 16.4 g of the compound (102), 22.8 g of the compound (103), and 7.1 g of the compound (105) was added (mole ratio: 40/50/10), and the mixture was retained at 25°C for 24 hours to perform hydrolytic condensation. After the reaction was finished, 450 g of propylene glycol monoethyl ether (PGEE) and 1.1 g of a 24% maleic acid aqueous solution were added, and the water content used for the hydrolytic condensation and a byproduct alcohol were distilled off under a reduced pressure to obtain 260 g of a PGEE solution of a polysiloxane resin A2 (resin concentration: 10%). A molecular weight of the polysiloxane resin A2 in terms of polystyrene was measured to Mw = 2,650.

### [Synthesis Example 1-3]

Into a mixture of 75 g of deionized water and 0.5 g of 7% nitric acid, a mixture of 11.4 g of the compound (102), 30.6 g of the compound (103), and 4.0 g of the compound (106) was added (mole ratio: 28/67/5), and the mixture was retained at 25°C for 24 hours to perform hydrolytic condensation. After the reaction was finished, 450 g of propylene glycol monoethyl ether (PGEE) and 1.0 g of a 24% maleic acid aqueous solution were added, and the water content used for the hydrolytic condensation and a byproduct alcohol were distilled off under a reduced pressure to obtain 240 g of a PGEE solution of a polysiloxane resin A3 (resin concentration: 10%). A molecular weight of the polysiloxane resin A3 in terms of polystyrene was measured to Mw = 2,500.

### [Synthesis Example 1-4]

Into a mixture of 75 g of deionized water and 0.5 g of 7% nitric acid, a mixture of 11.4 g of the compound (102), 30.6 g of the compound (103), and 4.2 g of the compound (107) was added (mole ratio: 28/67/5), and the mixture was retained at 25°C for 24 hours to perform hydrolytic condensation. After the reaction was finished, 450 g of propylene glycol monoethyl ether (PGEE) and 1.0 g of a 24% maleic acid aqueous solution were added, and the water content used for the hydrolytic condensation and a byproduct alcohol were distilled off under a reduced pressure to obtain 250 g of a PGEE solution of a polysiloxane resin A4 (resin concentration: 10%). A molecular weight of the polysiloxane resin A4 in terms of polystyrene was measured to Mw = 2,550.

### [Synthesis Example 1-5]

Into a mixture of 75 g of deionized water and 0.5 g of 7% nitric acid, a mixture of 11.4 g of the compound (102), 30.6 g of the compound (103), and 4.4 g of the compound (108) was added (mole ratio: 28/67/5), and the mixture was retained at 25°C for 24 hours to perform hydrolytic condensation. After the reaction was finished, 450 g of propylene glycol monoethyl ether (PGEE) and 1.1 g of a 24% maleic acid aqueous solution were added, and the water content used for the hydrolytic condensation and a byproduct alcohol were distilled off under a reduced pressure to obtain 250 g of a PGEE solution of a polysiloxane resin A5 (resin concentration: 10%). A molecular weight of the polysiloxane resin A5 in terms of polystyrene was measured to Mw = 2,600.

### [Comparative Synthesis Example 1-1]

Into a mixture of 75 g of deionized water and 0.5 g of 7% nitric acid, a mixture of 11.4 g of the compound (102), 30.6 g of the compound (103), and 4.2 g of the compound (109) was added (mole ratio: 28/67/5), and the mixture was retained at 25°C for 24 hours to perform hydrolytic condensation. After the reaction was finished, 450 g of propylene glycol monoethyl ether (PGEE) and 1.0 g of a 24% maleic acid aqueous solution were added, and the water content used for the hydrolytic condensation and a byproduct alcohol were distilled off under a reduced pressure to obtain 250 g of a PGEE solution of a polysiloxane resin X1 (resin concentration: 10%). A molecular weight of the polysiloxane resin X1 in terms of polystyrene was measured to Mw = 2,550.

### [Comparative Synthesis Example 1-2]

Into a mixture of 75 g of deionized water and 0.5 g of 7% nitric acid, a mixture of 3.0 g of the compound (101), 11.4 g of the compound (102), and 30.6 g of the compound (103) was added (mole ratio: 5/28/67), and the mixture was retained at 25°C for 24 hours to perform hydrolytic condensation. After the reaction was finished, 450 g of propylene glycol monoethyl ether (PGEE) and 1.0 g of a 24% maleic acid aqueous solution were added, and the water content used for the hydrolytic condensation and a byproduct alcohol were distilled off under a reduced pressure to obtain 240 g of a PGEE solution of a polysiloxane resin X2 (resin concentration: 10%). A molecular weight of the polysiloxane resin X2 in terms of polystyrene was measured to Mw = 2,500.

### [Crosslinking Catalyst]

XL-1: A compound represented by the following formula
(XL-1)
XL-2: A compound represented by the following formula
(XL-2)
XL-3: A compound represented by the following formula
(XL-3)

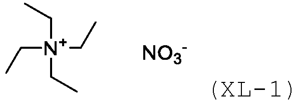

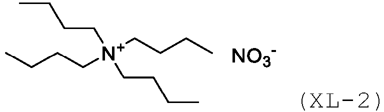

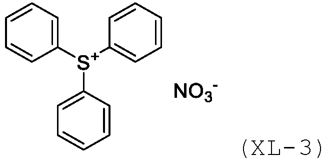

### [Solvent]

PGEE ··· Propylene glycol monoethyl ether
PGME ··· Propylene glycol monomethyl ether

[Preparation of Composition for Forming Silicon-Containing Film for Examples and Comparative Examples (Examples 1-1 to 1-6 and Comparative Examples 1-1 to 1-3)]

The polysiloxane resins A1 to A5 and comparative resins X1 to 2 obtained in the Synthesis Examples, the crosslinking catalysts (XL-1 to 3), an acid, a solvent, and water were mixed at ratios shown in Table 1, and the mixture was filtered with a 0.1-µm filter made of a fluororesin to prepare each of compositions for forming a silicon-containing film, Sol. 1 to 9.

**[Table 1]**

| | No. | Polysiloxane (parts by mass) | Crosslinking catalyst (parts by mass) | Acid (parts by mass) | Solvent (parts by mass) | Water (parts by mass) |
|---|---|---|---|---|---|---|
| Example 1-1 | Sol. 1 | A1 (1) | XL-1 (0.03) | Maleic acid (0.01) | PGEE (100) | Water (10) |
| Example 1-2 | Sol. 2 | A2 (1) | XL-2 (0.03) | Maleic acid (0.01) | PGEE (100) | Water (10) |
| Example 1-3 | Sol. 3 | A3 (1) | XL-1 (0.03) | Maleic acid (0.01) | PGEE (100) | Water (10) |
| Example 1-4 | Sol. 4 | A4 (1) | XL-2 (0.03) | Maleic acid (0.01) | PGEE (100) | Water (10) |
| Example 1-5 | Sol. 5 | A5 (1) | XL-1 (0.03) | Maleic acid (0.01) | PGEE (100) | Water (10) |
| Example 1-6 | Sol. 6 | A1 (1) | XL-2 (0.03) | Maleic acid (0.01) | PGEE (90) PGME (10) | Water (10) |
| Comparative Example 1-1 | Sol. 7 | X1 (1) | XL-1 (0.03) | Maleic acid (0.01) | PGEE (100) | Water (10) |
| Comparative Example 1-2 | Sol. 8 | X2 (1) | XL-2 (0.03) | Maleic acid (0.01) | PGEE (100) | Water (10) |
| Comparative Example 1-3 | Sol. 9 | A1 (1) | XL-3 (0.03) | Maleic acid (0.01) | PGEE (100) | Water (10) |

### [Production of Silicon Wafer with Formed Silicon-Containing Cured Film Using Compositions for Forming Silicon-Containing Film (Sol. 1 to 9)]

By using a coater/developer "CLEAN TRACK LITHIUS Pro AP", available from Tokyo Electron Ltd., 2 ml of the compositions for forming a silicon-containing film (Sol. 1 to 9) prepared above was discharged at a center of a silicon wafer, the silicon wafer was rotated for spreading at a rotation speed so that the average film thickness after baking was 50 nm to form a film. Then, the silicon wafer with the formed film of the composition for forming a silicon-containing film was heated at 220 degrees for 60 seconds to obtain silicon wafers with a formed silicon-containing cured film (Films 1 to 9).

### [Transmissivity Evaluation: Films 1 to 9 (Examples 2-1 to 2-6 and Comparative Examples 2-1 to 2-3)]

Regarding Films 1 to 9 formed on the silicon wafer by the above method, an nk value was measured to calculate transmissivity. As transmissivity with a film thickness of 50 nm, a case where the lowest transmissivity in a wavelength region from 200 nm to 400 nm was 98% or more was judged as "Good", and a case where the transmissivity was less than 98% was judged as "Poor". Table 2 shows the results.

**[Table 2]**

| | | Transmissivity |
|---|---|---|
| Example 2-1 | Film 1 | Good |
| Example 2-2 | Film 2 | Good |
| Example 2-3 | Film 3 | Good |
| Example 2-4 | Film 4 | Good |
| Example 2-5 | Film 5 | Good |
| Example 2-6 | Film 6 | Good |
| Comparative Example 2-1 | Film 7 | Good |
| Comparative Example 2-2 | Film 8 | Poor |
| Comparative Example 2-3 | Film 9 | Poor |

As shown in Table 2, Films 1 to 6 of the silicon-containing film composed of the composition for forming a silicon-containing film of the present invention having no aromatic ring exhibited good transmissivity. Meanwhile, Films 8 and 9 with composition having an aromatic ring did not have sufficient transmissivity. It can be said that Films 8 and 9 are unsuitable as the film on the super straight, and Films 8 and 9 were not subjected to further evaluation.

### [Evaluation of Contact Angle after Plasma Treatment Relative to Pure Water: Films 1 to 7 (Examples 3-1 to 3-6 and Comparative Example 3-1)]

Films 1 to 7 formed on the silicon wafer by the above method were subjected to an O₂-plasma treatment by using an etching apparatus Telius, available from Tokyo Electron Ltd. The plasma treatment condition was as shown below. Thereafter, the contact angle relative to pure water was measured. A case where the contact angle relative to pure water was 20 degrees or less was judged as "Good", and a case where the contact angle was more than 20 degrees was judged as "Poor". Table 3 shows the results.

### (Plasma Treatment Condition for Silicon-Containing Film)

| | |
|---|---|
| Chamber pressure | 2.0 Pa |
| RF power | 500 W |
| Ar gas flow rate | 75 mL/min |
| O₂ gas flow rate | 45 mL/min |
| Time | 10 sec. |

**[Table 3]**

| | | Contact angle after plasma treatment |
|---|---|---|
| Example 3-1 | Film 1 | Good |
| Example 3-2 | Film 2 | Good |
| Example 3-3 | Film 3 | Good |
| Example 3-4 | Film 4 | Good |
| Example 3-5 | Film 5 | Good |
| Example 3-6 | Film 6 | Good |
| Comparative Example 3-1 | Film 7 | Poor |

As shown in Table 3, Films 1 to 6 of the silicon-containing films composed of the composition for forming a silicon-containing film of the present invention having the organic group that formed a diol structure with the plasma treatment exhibited a good contact angle after the plasma treatment. Meanwhile, Film 7 that did not have the organic group that formed a diol structure in the structure did not exhibit a sufficient contact angle. Thus, Film 7 was not subjected to further evaluation.

### [In-Plane Uniformity Evaluation: Films 1 to 6 (Examples 4-1 to 4-6)]

Regarding Films 1 to 6 formed on the silicon wafer by the above method, film thicknesses within a diameter of 145 mm from the center of the silicon-containing cured film were measured, and a value determined by (Xₘₐₓ-Xₘᵢₙ) /X_{average} × 100, wherein Xₘₐₓ was the maximum value of the film thickness, Xₘᵢₙ was the minimum value of the film thickness, and X_{average} was an average film thickness, to be specified as in-plane uniformity (%). A case where the in-plane uniformity was less than 2% was judged as "A (Good)", a case where the in-plane uniformity was 2% or more and less than 3% was judged as **"B",** and a case where the in-plane uniformity was 3% or more was judged as "C (Poor)". Table 4 shows the results.

**[Table 4]**

| | | In-plane uniformity |
|---|---|---|
| Example 4-1 | Film 1 | A |
| Example 4-2 | Film 2 | A |
| Example 4-3 | Film 3 | A |
| Example 4-4 | Film 4 | A |
| Example 4-5 | Film 5 | A |
| Example 4-6 | Film 6 | A |

As shown in Table 4, all the silicon-containing cured films using the composition for forming a silicon-containing film of the present invention exhibited good results. It is understood that the silicon-containing cured film can be used for planarizing the surface of the super straight.

From the above, it can be said that the composition for forming a silicon-containing film of the present invention has excellent film formability, in-plane uniformity, and light transmittance, and is extremely useful as the organic film material for the super straight used for the inkjet-adaptive planarization.

### [EUV Patterning Test (Examples 5-1 to 5-6)]

Sol. 1 to 6 were applied on a silicon wafer by spin-coating as a composition for forming a silicon-containing resist underlayer film, and heated at 220°C for 60 seconds to produce Films 1 to 6 being silicon-containing resist underlayer films with 50 nm in film thickness.

Subsequently, a resist material in which the following components were dissolved at a ratio in Table 5 was applied on Films 1 to 6 by spin-coating, and prebaked at 105°C for 60 seconds by using a hotplate to produce a resist upper layer film with 60 nm in film thickness. This resist film was exposed by using an EUV scanner NXE3300 (NA: 0.33, σ: 0.9/0.6, quadrupole illumination, hole pattern mask with 46 nm in pitch on wafer size and +20% bias), available from ASML Holding N.V. PEB was performed at 100°C for 60 seconds on a hotplate, and development was performed with a 2.38-mass% aqueous TMAH solution for 30 seconds to obtain a hole pattern with 23 nm in size. By using a lengthmeasurement SEM (CG5000), available from Hitachi High-Technologies Corporation, an exposure dose when the hole pattern was formed with 23 nm in size was measured to specify this exposure dose as a sensitivity. Sizes of 50 holes in this time were measured, and dimensional deviation (CDU, 3σ) was determined. A case where the value of the dimensional deviation (CDU, 3σ) was 2.5 nm or less was judged as "Good", and the dimensional deviation (CDU, 3σ) was more than 2.5 nm was judged as "Poor". Table 6 shows the results.

A polymer, a quencher, a sensitizer, a surfactant, and an organic solvent used as the resist material were as shown below. 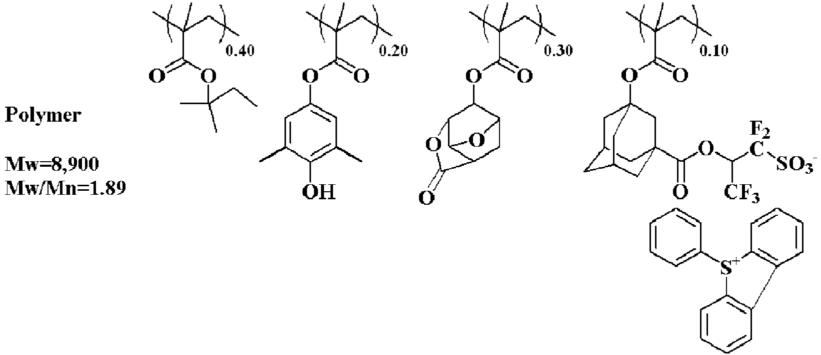 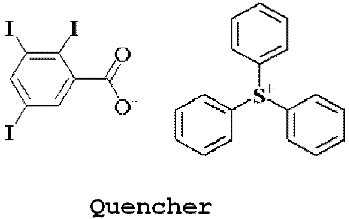 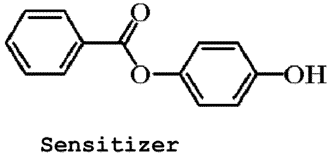
Surfactant: FC-4430, available from 3M Company PGMEA: Propylene glycol monomethyl ether acetate CyHO: Cyclohexanone
PGME: Propylene glycol monomethyl ether

**[Table 5]**

| Component | Polymer | Quencher | Sensitizer | Surfactant | Organic Solvent |
|---|---|---|---|---|---|
| Composition (parts by mass) | (100) | (100) | (2.1) | (0.25) | PGMEA (400) |
| | | | | | CyHO (2000) |
| | | | | | PGME (100) |

**[Table 6]**

| | | Dimentional deviation (CDU, 3σ) in EUV patterning |
|---|---|---|
| Example 5-1 | Film 1 | Good |
| Example 5-2 | Film 2 | Good |
| Example 5-3 | Film 3 | Good |
| Example 5-4 | Film 4 | Good |
| Example 5-5 | Film 5 | Good |
| Example 5-6 | Film 6 | Good |

As shown in Table 6, the composition for forming a silicon-containing film of the present invention can also be used as the composition for forming a resist underlayer film in EUV patterning.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

For example, the cases where the composition for forming a silicon-containing film of the present invention is used for the super straight or the resist underlayer film have been exemplified and described above, but the present invention is not limited to these cases. The present invention can be applied for any application of forming an organic film requiring planarization, low contact angle, transparency, etc.

## Claims

1. A composition for forming a silicon-containing film, the composition comprising a condensation-reactive thermally curable silicon-containing material (Sx) being a polysiloxane resin, wherein
the material (Sx) has an organic group that forms a diol structure with a plasma treatment,
the composition for forming a silicon-containing film has no aromatic ring, and
a contact angle of the composition for forming a silicon-containing film after curing and after the plasma treatment relative to pure water is 20 degrees or less.

2. The composition for forming a silicon-containing film according to claim 1, wherein
the polysiloxane resin of the material (Sx) comprises repeating units represented by the following formula (Sx-1), the following formula (Sx-2), and the following formula (Sx-3), and
the composition for forming a silicon-containing film further comprises: the following crosslinking catalyst for polymerizing a siloxane (Xc) having no aromatic ring; an alcoholic organic solvent; and water, 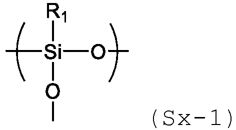
wherein R₁ represents a monovalent organic group having 1 to 20 carbon atoms, having no aromatic ring, optionally having a substituent, and having one or more cyclic structures having an oxygen atom for forming the diol structure with the plasma treatment, 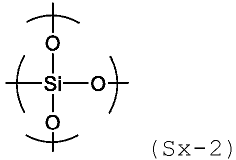 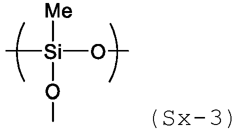
wherein Me represents a methyl group, 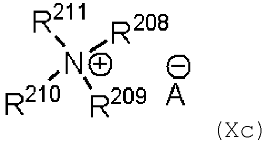
wherein R²⁰⁸, R²⁰⁹, R²¹⁰, and R²¹¹ each represent a hydrogen atom or a linear, branched, or cyclic alkyl group, alkenyl group, oxoalkyl group, or oxoalkenyl group having 1 to 12 carbon atoms, and a part or all of hydrogen atoms in these groups may be substituted with an alkoxy group, etc.; and R²⁰⁸ and R²⁰⁹, or R²⁰⁸, R²⁰⁹, and R²¹⁰ may form a ring, and when forming the ring, R²⁰⁸ and R²⁰⁹, and R²⁰⁸, R²⁰⁹, and R²¹⁰ represent an alkylene group having 3 to 10 carbon atoms.

3. The composition for forming a silicon-containing film according to claim 2, wherein R₁ represented in the general formula (Sx-1) is represented by the following general formula (A-1), and forms the diol structure with the plasma treatment, 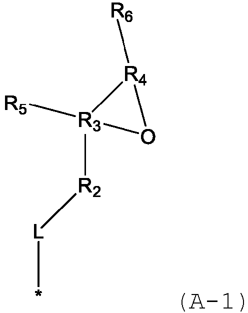 wherein L represents a single bond or a divalent organic group having 1 to 5 carbon atoms; R₂, R₃, and R₄ each independently represent an organic group having 1 to 5 carbon atoms and optionally having a substituent; R₅ and R₆ each independently represent a hydrogen atom or an organic group having 1 to 5 carbon atoms and optionally having a substituent, and R₂ and R₆ may form a cyclic structure; and "*" represents an attachment point to a Si atom.

4. A method for forming a silicon-containing film, the method comprising steps of:
forming a carbon hard mask layer on a substrate in which a film is optionally formed on a surface; and
forming a film by curing the composition for forming a silicon-containing film according to any one of claims 1 to 3 on the carbon hard mask layer.

5. A method for forming a silicon-containing film, the method comprising steps of:
forming a carbon hard mask layer on a substrate in which a film is optionally formed on a surface;
forming a film by curing the composition for forming a silicon-containing film according to any one of claims 1 to 3 on the carbon hard mask layer; and
subjecting the film to a plasma treatment to set a contact angle of a surface of the formed silicon-containing film relative to pure water to 20 degrees or less.

6. A method for forming a silicon-containing film, the method comprising a step of applying the composition for forming a silicon-containing film according to any one of claims 1 to 3 on a super straight comprising a quartz substrate or a laminated body, and subjecting the substrate on which the composition for forming a silicon-containing film is applied to a thermal treatment at a temperature of 100°C or higher and 600°C or lower for a range of 10 to 600 seconds to form a cured film.

7. A super straight, comprising:
a main body of the super straight;
a first layer having a proximal surface and a distal surface opposite to the proximal surface, wherein the main body is closer to the proximal surface of the first layer than to the distal surface of the first layer; and
a second layer having a proximal surface and a distal surface opposite to the proximal surface, wherein the main body is closer to the proximal surface of the second layer than to the distal surface of the second layer, wherein
the first layer is placed between the main body and the second layer,
the second layer is a cured product of the composition for forming a silicon-containing film according to any one of claims 1 to 3, and
a contact angle of the cured product after a plasma treatment relative to pure water is 20 degrees or less.
